# EUROPEAN PATENT APPLICATION

(11) **EP 3 511 377 A1**
(43) Date of publication of application: **17.07.2019**
(21) Application number: 17848696.5
(22) Date of filing: 04.09.2017
(51) Int. Cl.: C08L 83/04, C08G 77/50, C08L 83/06, G02B 5/20

(54) **SILICONE RESIN COMPOSITION, WAVELENGTH CONVERSION MATERIAL-CONTAINING SILICONE RESIN COMPOSITION, AND WAVELENGTH CONVERSION MATERIAL-CONTAINING SHEET**

(30) Priority: 07.09.2016 JP 2016175089
(71) Applicant: Sumitomo Chemical Co., Ltd., Tokyo 104-8260 (JP)
(72) Inventor: MASUI, Kentaro, Osaka-shi Osaka 554-8558 (JP); DOI, Atsunori, Tsukuba-shi Ibaraki 300-3294 (JP)
(74) Representative: Winter, Brandl, Fürniss, Hübner, Röss, Kaiser, Polte - Partnerschaft mbB
(86) International application number: PCT/JP2017/031728
(87) International publication number: WO 2018/047756

(57) **Abstract**

Provided is a silicone resin composition having good coating properties whose cured product after curing has excellent heat resistance.

A silicone resin composition containing a silicone resin and a solvent, wherein
the silicone resin composition is a liquid composition having a viscosity of 100 to 50000 mPa·s at 25°C,
the silicone resin contains a structural unit represented by the following formula (A3), and
the total content of a structural unit represented by the following formula (A1), a structural unit represented by the following formula (A1'), a structural unit represented by the following formula (A2) and the structural unit represented by the following formula (A3) contained in the silicone resin to the total content of all structural units contained in the silicone resin is 80% by mole or more, 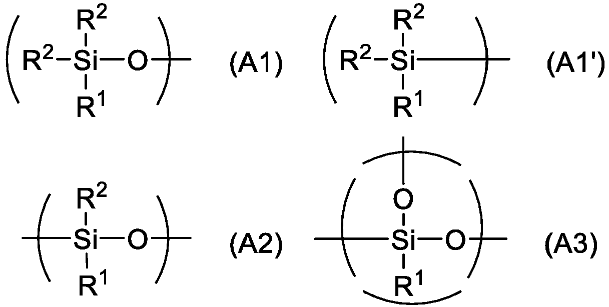 wherein R¹ represents an alkyl group or an aryl group; and R² represents an alkoxy group or a hydroxyl group.

## Description

### TECHNICAL FIELD

The present invention relates to a silicone resin composition, a wavelength conversion material-containing silicone resin composition, and a wavelength conversion material-containing sheet.

### BACKGROUND ART

A laser diode (LD, Laser Diode) can maintain high conversion efficiency even in a high current density region. Further, it is also possible to downsize a device by separating a light emitting portion and an excitation portion of the laser diode. Therefore, it is expected to use a laser diode for a lighting device.

An emission spectrum of a laser diode depends on a semiconductor material which is a material for forming the laser diode. Currently, a method of emitting all three colors of RGB by a laser diode (the former method), and a method for obtaining white light by arranging an LD element and a wavelength conversion material, irradiating the wavelength conversion material with light emitted from the LD element and converting an emission wavelength (the latter method) are adopted. Since the latter method is suitable for downsizing of the device, development to applications such as projectors has been studied.

A light-emitting device in which a sheet containing a phosphor as a wavelength conversion material (hereinafter sometimes referred to as "phosphor sheet") is arranged on a light emitting surface of a light emitting diode (LED) element is known (see, for example, Patent Document 1). There is also known a wavelength conversion member in which inorganic phosphor powder is dispersed in a glass matrix (see, for example, Patent Document 2).

### PRIOR ART DOCUMENTS

### PATENT DOCUMENTS

Patent Document 1: JP-A-2013-001792
Patent Document 2: JP-A-2013-095849

### SUMMARY OF THE INVENTION

### PROBLEMS TO BE SOLVED BY THE INVENTION

A laser diode emits light having a higher energy density than a light emitting diode. Therefore, a phosphor sheet for LD is required to have higher heat resistance than a phosphor sheet for LED. The phosphor sheet described in Patent Document 1 does not have sufficient heat resistance as the phosphor sheet for LD in some cases. Specifically, when light emitted from a laser diode is irradiated to the phosphor sheet described in Patent Document 1, a resin contained in the phosphor sheet deteriorates due to heat generation accompanying high energy density light irradiation, and cracks, coloration, wrinkles and the like occur in some cases.

Although the wavelength conversion member described in Patent Document 2 has excellent heat resistance, the inorganic phosphor powder deteriorates during sintering of a glass matrix in some cases since the sintering temperature of the glass matrix is 350 to 900°C. Further, the wavelength conversion member described in Patent Document 2 is difficult to be applied on a substrate, and it is also difficult to process after sintering.

The present invention has been made in view of such circumstances, and an object thereof is to provide a silicone resin composition having good coating properties whose cured product after curing has excellent heat resistance.

### MEANS FOR SOLVING THE PROBLEMS

In order to solve the above problem, the present invention provides the following [1] to [15].
[1] A silicone resin composition containing a silicone resin and a solvent, wherein
   the silicone resin composition is a liquid composition having a viscosity of 100 to 50000 mPa·s at 25°C,
   the silicone resin contains a structural unit represented by the following formula (A3), and
   the total content of a structural unit represented by the following formula (A1), a structural unit represented by the following formula (A1'), a structural unit represented by the following formula (A2) and the structural unit represented by the following formula (A3) contained in the silicone resin to the total content of all structural units contained in the silicone resin is 80% by mole or more. 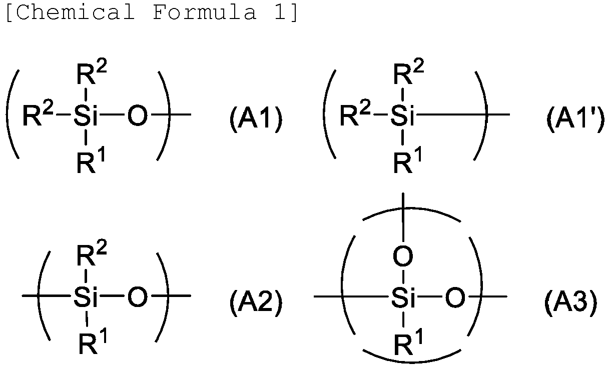 In the formulas (A1), (A1'), (A2) and (A3),
   R¹ represents an alkyl group having 1 to 10 carbon atoms or an aryl group having 6 to 10 carbon atoms;
   R² represents an alkoxy group having 1 to 4 carbon atoms or a hydroxyl group; and
   a plurality of R¹s and R²s each may be the same or different.
[2] The silicone resin composition according to [1], wherein the content of the structural unit represented by the formula (A3) contained in the silicone resin to the total content of all structural units contained in the silicone resin is 55% by mole or more.
[3] The silicone resin composition according to [1] or [2], wherein the content of the solvent contained in the silicone resin composition to the total content of all components contained in the silicone resin composition is 10 to 40% by mass.
[4] The silicone resin composition according to any of [1] to [3], wherein the silicone resin is substantially composed of a condensation type silicone resin.
[5] The silicone resin composition according to any of [1] to [4], wherein the R¹ is a methyl group, and the R² is an alkoxy group having 1 to 3 carbon atoms or a hydroxyl group.
[6] The silicone resin composition according to any of [1] to [5], wherein the silicone resin has a polystyrene equivalent weight average molecular weight of 1500 to 15000.
[7] The silicone resin composition according to any of [1] to [6], wherein
   the silicone resin contains a first oligomer,
   the first oligomer contains a structural unit represented by the following formula (B2), and
   the first oligomer has a polystyrene equivalent weight average molecular weight of 1000 to 10000. 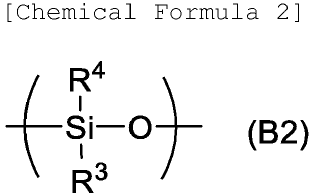 wherein
   R³ represents an alkyl group having 1 to 10 carbon atoms or an aryl group having 6 to 10 carbon atoms; and
   R⁴ represents an alkyl group having 1 to 10 carbon atoms, an aryl group having 6 to 10 carbon atoms, an alkoxy group having 1 to 4 carbon atoms or a hydroxyl group.
[8] The silicone resin composition according to [7], wherein the content of the structural unit represented by the formula (B2) contained in the first oligomer in which the R⁴ is an alkoxy group having 1 to 4 carbon atoms or a hydroxyl group to the total content of all structural units contained in the first oligomer is 30 to 60% by mole.
[9] The silicone resin composition according to [7] or [8], wherein the first oligomer contains a structural unit represented by the following formula (B1), formula (B1'), formula (B2) or formula (B3), and
   the average composition formula of the first oligomer is represented by the following formula (I). 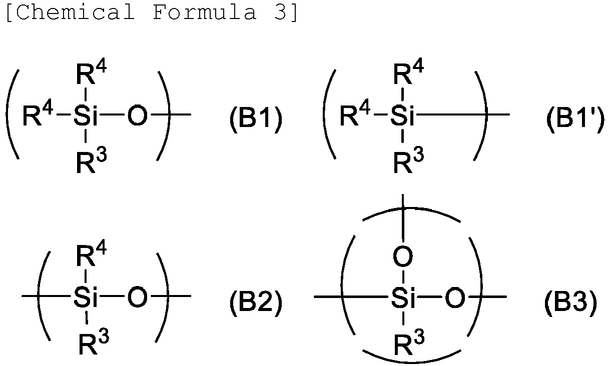 In the formulas (B1), (B1'), (B2) and (B3),
   R³ represents an alkyl group having 1 to 10 carbon atoms or an aryl group having 6 to 10 carbon atoms;
   R⁴ represents an alkyl group having 1 to 10 carbon atoms, an aryl group having 6 to 10 carbon atoms, an alkoxy group having 1 to 4 carbon atoms or a hydroxyl group; and
   a plurality of R³s and R⁴s each may be the same or different.

      (R⁵)ₙSi (OR⁶)ₘO_{(4-n-m)/2} ... (I)

      wherein
      R⁵ represents an alkyl group having 1 to 10 carbon atoms or an aryl group having 6 to 10 carbon atoms;
      R⁶ represents an alkyl group having 1 to 10 carbon atoms, an aryl group having 6 to 10 carbon atoms or a hydrogen atom;
      n represents a real number satisfying 1 < n < 2; and m represents a real number satisfying 0 < m < 1.
[10] The silicone resin composition according to any of [7] to [9] wherein the molar ratio of the following T unit and D unit contained in the first oligomer is from 60 : 40 to 90 : 10.
   wherein,
   T unit means a structural unit containing a silicon atom bonded to three oxygen atoms, and
   D unit means a structural unit containing a silicon atom bonded to two oxygen atoms.
[11] The silicone resin composition according to any of [1] to [10], wherein
   the silicone resin contains a second oligomer,
   the second oligomer contains a structural unit represented by the formula (A1), the formula (A1'), the formula (A2) or the formula (A3),
   the content of the structural unit represented by the formula (A3) contained in the second oligomer, to the total content of the structural unit represented by the formula (A1), the structural unit represented by the formula (A1'), the structural unit represented by the formula (A2) and the structural unit represented by the formula (A3), is 0 to 30% by mole, and
   the second oligomer has a polystyrene equivalent weight average molecular weight of less than 1500.
[12] A wavelength conversion material-containing silicone resin composition containing the silicone resin composition as defined in any of [1] to [11] and a wavelength conversion material.
[13] The wavelength conversion material-containing silicone resin composition according to [12], which is a liquid composition having a viscosity of 1000 to 500000 mPa·s at 25°C.
[14] The wavelength conversion material-containing silicone resin composition according to [12] or [13], wherein the content of the wavelength conversion material to the total content of all components contained in the wavelength conversion material-containing silicone resin composition is 40% by mass or more.
[15] A wavelength conversion material-containing sheet containing a cured product of the wavelength conversion material-containing silicone resin composition as defined in any of [12] to [14] as a forming material.

### EFFECT OF THE INVENTION

According to the present invention, it is possible to provide a silicone resin composition having good coating properties whose cured product after curing has excellent heat resistance.

### BRIEF DESCRIPTION OF THE DRAWINGS

Fig. 1 is a cross-sectional view showing one embodiment of a light-emitting device including a wavelength conversion sheet.
Fig. 2 is a cross-sectional view showing one embodiment of a light-emitting device having a wavelength conversion sheet.

### MODE FOR CARRYING OUT THE INVENTION

Hereinafter, embodiments of the present invention will be described.

The structural unit contained in a silicone resin is preferably contained in the silicone resin as a repeating unit.

### <Silicone Resin Composition>

A silicone resin composition of the present embodiment contains a silicone resin and a solvent, wherein the silicone resin composition is a liquid composition having a viscosity of 100 to 50000 mPa·s at 25°C and contains a structural unit represented by the following formula (A3) and the total content of a structural unit represented by the following formula (A1), a structural unit represented by the following formula (A1'), a structural unit represented by the following formula (A2) and the structural unit represented by the following formula (A3) contained in the silicone resin to the total content of all structural units contained in the silicone resin is 80% by mole or more. 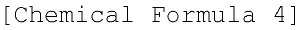 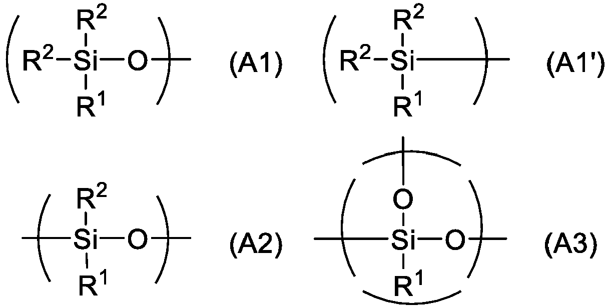 In the formulas (A1), (A1'), (A2) and (A3),
R¹ represents an alkyl group having 1 to 10 carbon atoms or an aryl group having 6 to 10 carbon atoms;
R² represents an alkoxy group having 1 to 4 carbon atoms or a hydroxyl group; and
a plurality of R¹s and R²s each may be the same or different.

As shown in the examples, the silicone resin composition of the present embodiment has good coating properties, and the cured product (matrix) after curing has excellent heat resistance. Therefore, the silicone resin composition of the present embodiment is suitable, for example, as a material for forming a phosphor sheet for LD, and is also suitable for a material for forming a sealing layer of LED. Since the silicone resin composition of the present embodiment is excellent in all of coating properties, heat resistance and filler acceptability, it is particularly suitable for a material for forming a phosphor sheet for LD.

The viscosity of the silicone resin composition of the present embodiment is preferably 300 to 20000 mPa·s, more preferably 400 to 15000 mPa·s, and further preferably 500 to 10000 mPa·s at 25°C.

When the viscosity of the silicone resin composition of the present embodiment is within the above range at 25°C, in a case where the silicone resin composition is mixed with a wavelength conversion material, mixing performance with the wavelength conversion material is improved and sedimentation of the wavelength conversion material is suppressed.

### (Silicone Resin)

The silicone resin contained in the silicone resin composition of the present embodiment may be of one type alone or two or more types.

The structural unit contained in the silicone resin contained in the silicone resin composition of the present embodiment will be described.

In the present specification, a structural unit containing a silicon atom bonded to three oxygen atoms is referred to as "T unit".

Also, a structural unit containing a silicon atom in which all the three oxygen atoms are bonded to other silicon atoms is referred to as "T3 unit".

Further, a structural unit containing a silicon atom in which two oxygen atoms among the three oxygen atoms are bonded to other silicon atoms is referred to as "T2 unit".

Moreover, a structural unit containing a silicon atom in which one oxygen atom among the three oxygen atoms is bonded to another silicon atom is referred to as "T1 unit".

That is, the "T unit" means "T1 unit", "T2 unit" and "T3 unit".

In the present specification, a structural unit containing a silicon atom bonded to two oxygen atoms is referred to as "D unit". A structural unit containing a silicon atom bonded to one oxygen atom is referred to as "M unit".

The structural unit represented by the formula (A3) contains three oxygen atoms bonded to other silicon atoms and a silicon atom bonded to R¹. Since R¹ is an alkyl group having 1 to 10 carbon atoms or an aryl group having 6 to 10 carbon atoms, the structural unit represented by the formula (A3) is a T3 unit.

The structural unit represented by the formula (A2) contains two oxygen atoms bonded to other silicon atoms, and a silicon atom bonded to R¹ and R². Since R² is an alkoxy group having 1 to 4 carbon atoms or a hydroxyl group, the structural unit represented by the formula (A2) is a T2 unit.

The structural unit represented by the formula (A1) contains one oxygen atom bonded to another silicon atom, and a silicon atom bonded to R¹ and two R²s. Since R¹ is an alkyl group having 1 to 10 carbon atoms or an aryl group having 6 to 10 carbon atoms and R² is an alkoxy group having 1 to 4 carbon atoms or a hydroxyl group, the structural unit represented by the formula (A1) is a T1 unit.

The structural unit represented by the formula (A1') contains a silicon atom bonded to R¹ and two R²s, and the silicon atom is bonded to an oxygen atom bonded to a silicon atom in another structural unit. Since R¹ is an alkyl group having 1 to 10 carbon atoms or an aryl group having 6 to 10 carbon atoms and R² is an alkoxy group having 1 to 4 carbon atoms or a hydroxyl group, the structural unit represented by the formula (A1') is a T1 unit.

The structural unit represented by the formula (A1) and the structural unit represented by the formula (A1') constitute an end of an organopolysiloxane chain contained in a condensation type silicone resin. Further, the structural unit represented by the formula (A3) constitutes a branched chain structure of the organopolysiloxane chain contained in the condensation type silicone resin. That is, the structural unit represented by the formula (A3) forms a part of a network structure and a ring structure in the condensation type silicone resin.

In the present specification, the silicon atom contained in the T3 unit is referred to as "T3 silicon atom". Also, the silicon atom contained in the T2 unit is referred to as "T2 silicon atom". Moreover, the silicon atom contained in the T1 unit is referred to as "T1 silicon atom".

In the silicone resin contained in the silicone resin composition of the present embodiment, the content of T units (that is, the total content of T1 unit, T2 unit and T3 unit) to the total content of all structural units contained in the silicone resin is preferably 80% by mole or more. In other words, the total content of T1 silicon atoms, T2 silicon atoms and T3 silicon atoms to the total content of all silicon atoms contained in the silicone resin is preferably 80% by mole or more.

The silicone resin contained in the silicone resin composition of the present embodiment contains the structural unit represented by the formula (A3), and may further contain one or more structural units selected from the group consisting of the structural unit represented by the formula (A1), the structural unit represented by the formula (A1'), and the structural unit represented by the formula (A2).

The silicone resin contained in the silicone resin composition of the present embodiment preferably contains all of the structural unit represented by the formula (A1), the structural unit represented by the formula (A1'), the structural unit represented by the formula (A2), and the structural unit represented by the formula (A3).

In the present specification, when the silicone resin contained in the silicone resin composition of the present embodiment contains an oligomer component to be described later, the phrase "all structural units contained in the silicone resin contained in the silicone resin composition of the present embodiment" includes a structural unit contained in an oligomer component.

In the silicone resin contained in the silicone resin composition of the present embodiment, the content of the structural unit represented by the formula (A3) to the total content of all structural units contained in the silicone resin is preferably 55% by mole or more, more preferably 60% by mole or more, further preferably 65% by mole or more, and particularly preferably 70% by mole or more.

That is, in the silicone resin contained in the silicone resin composition of the present embodiment, the content of the T3 unit to the total content of all structural units contained in the silicone resin is preferably 55% by mole or more, more preferably 60% by mole or more, further preferably 65% by mole or more, and particularly preferably 70% by mole or more. In other words, the content of the T3 silicon atoms contained in the silicone resin to the total content of all silicon atoms contained in the silicone resin is preferably 55% by mole or more, more preferably 60% by mole or more, further preferably 65% by mole or more, and particularly preferably 70% by mole or more.

As shown in the examples, in the silicone resin contained in the silicone resin composition of the present embodiment, when the content of the T unit and the content of the T3 unit are within the above ranges, a cured product of the silicone resin composition shows sufficient heat resistance and also shows high light transmittance even after a heat resistance test.

The content of the T3 silicon atoms can be determined as the ratio of the area of a signal assigned as the T3 silicon atom to the total area of signals of all silicon atoms determined in ²⁹Si-NMR measurement. The contents of T1 silicon atoms and T2 silicon atoms can also be determined by the same method.

In the structural unit represented by the formula (A1), the structural unit represented by the formula (A1'), the structural unit represented by the formula (A2) and the structural unit represented by the formula (A3), R¹ is preferably an alkyl group, and from the viewpoint of heat resistance, it is preferably a methyl group.

The carbon number of 1 to 10 represented by R¹ may be a linear alkyl group, a branched chain alkyl group, or an alkyl group having a cyclic structure. Among them, a linear or branched alkyl group is preferable, a linear alkyl group is more preferable, and a methyl group is further preferable.

In the alkyl group having 1 to 10 carbon atoms represented by R¹, one or more hydrogen atoms constituting the alkyl group may be substituted with other functional groups. Examples of the substituent of the alkyl group include aryl groups having 6 to 10 carbon atoms such as a phenyl group and naphthyl group, and a phenyl group is preferable.

Examples of the alkyl group having 1 to 10 carbon atoms represented by R¹ include unsubstituted alkyl groups such as a methyl group, ethyl group, n-propyl group, isopropyl group, n-butyl group, isobutyl group, tert-butyl group, n-pentyl group, neopentyl group, hexyl group, octyl group, nonyl group and decyl group, and aralkyl groups such as a phenylmethyl group, phenylethyl group, and phenylpropyl group. Among them, a methyl group, ethyl group, n-propyl group, isopropyl group or n-butyl group is preferable, a methyl group, ethyl group or isopropyl group is more preferable, and a methyl group is further preferable.

In the aryl group having 6 to 10 carbon atoms represented by R¹, one or more hydrogen atoms constituting the aryl group may be substituted with other functional group. Examples of the substituent of the aryl group include alkyl groups having 1 to 10 carbon atoms such as a methyl group, ethyl group, n-propyl group, and n-butyl group.

Examples of the aryl group having 6 to 10 carbon atoms represented by R¹ include unsubstituted aryl groups such as a phenyl group and naphthyl group; and alkylaryl groups such as a methylphenyl group, ethylphenyl group and propylphenyl group. Among them, a phenyl group is preferable.

In the structural unit represented by the formula (A1), the structural unit represented by the formula (A1') and the structural unit represented by the formula (A2), and R² is preferably a methoxy group, ethoxy group, isopropoxy group, or hydroxyl group.

The alkoxy group having 1 to 4 carbon atoms represented by R² may be a linear alkoxy group, a branched chain alkoxy group, or an alkoxy group having a cyclic structure. Among them, a linear or branched alkoxy group is preferable, and a linear alkoxy group is more preferable.

Examples of the alkoxy group having 1 to 4 carbon atoms represented by R² include a methoxy group, ethoxy group, n-propoxy group, isopropoxy group, n-butoxy group, isobutoxy group and tert-butoxy group, and from the viewpoint of achieving stability and curability of the silicone resin composition of the present embodiment in a well-balanced manner, a methoxy group, ethoxy group or isopropoxy group is preferable .

The silicone resin contained in the silicone resin composition of the present embodiment is preferably substantially composed of a condensation type silicone resin. Here, the condensation type silicone resin refers to a resin polycondensed by dealcoholization reaction or dehydration reaction of a hydroxyl group bonded to a silicon atom and an alkoxy group or hydroxyl group bonded to another silicon atom. The addition type silicone resin refers to a resin polymerized by addition reaction of a hydrosilyl group and a carbon-carbon double bond. In addition, although there is a resin polymerized by simultaneous addition reaction and polycondensation reaction, it is treated as one type of addition type in this specification. Here, the phrase "substantially composed of a condensation type silicone resin" means a form that the silicone resin contained in the wavelength conversion material-containing silicone resin composition composed of only a condensation type silicone resin, and a form that contains another silicone resin on a level that does not deteriorate heat resistance of a cured product of the wavelength conversion material-containing silicone resin composition. Here, the phrase "on a level that does not deteriorate heat resistance of a cured product" means that the degree of deterioration of the heat resistance is a practically acceptable level. Specifically, it means that the content of the another silicone resin to the total content of the silicone resin contained in the wavelength conversion material-containing silicone resin composition is 1% by mass or less, and preferably 0.1% by mass or less.

When the silicone resin contained in the silicone resin composition of the present embodiment is a resin substantially composed of a condensation type silicone resin, the cured product of the silicone resin composition can maintain higher light transmittance after a heat resistance test.

In the silicone resin contained in the silicone resin composition of the present embodiment, it is preferable that, in the structural unit represented by the formula (A1), the structural unit represented by the formula (A1'), the structural unit represented by the formula (A2), and the structural unit represented by the formula (A3), R¹ is a methyl group, and R² is an alkoxy group having 1 to 3 carbon atoms or a hydroxyl group.

Also, the polystyrene equivalent weight average molecular weight of the silicone resin contained in the silicone resin composition of the present embodiment is preferably 1500 to 15000, more preferably 2000 to 10000, further preferably 2000 to 8000, and particularly preferably 2500 to 6000. When the polystyrene equivalent weight average molecular weight of the silicone resin is within the above range, curability and solubility in a solvent are excellent, so that handling properties and coating properties when using the silicone resin composition are improved.

Generally, the weight average molecular weight of the silicone resin can use a value measured by a gel permeation chromatography (GPC) method. Specifically, after dissolving the silicone resin in a soluble solvent, the obtained solution is passed through a column using a filler in which many pores are present together with a mobile phase solvent to separate the silicone resin in the column depending on the levels of the molecular weight. The content of the separated molecular weight component is detected by using a differential refractometer, a UV meter, a viscometer, a light scattering detector or the like as a detector. A dedicated GPC instrument is widely commercially available, and the weight average molecular weight is generally measured in terms of standard polystyrene. The weight average molecular weight in this specification is measured in terms of standard polystyrene.

The silicone resin contained in the silicone resin composition of the present embodiment may further contain a structural unit represented by the following formula (C1), formula (C1'), formula (C2), formula (C3) or formula (C4). 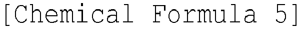 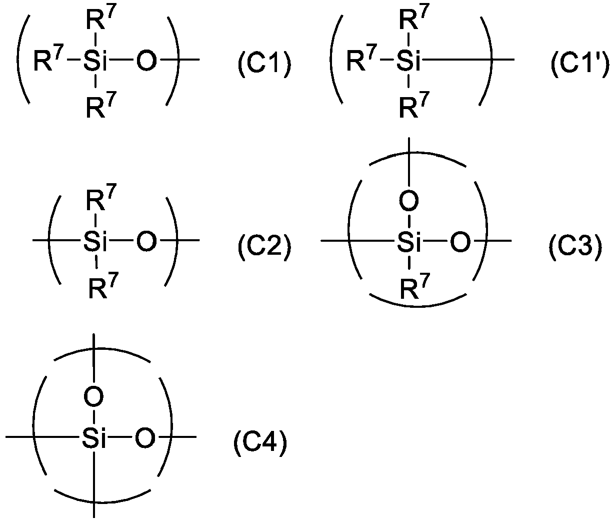 In the formula (C1), formula (C1'), formula (C2), formula (C3) and formula (C4), R⁷ represents an alkoxy group having 1 to 4 carbon atoms or a hydroxyl group, and a plurality of R⁷s each may be the same or different.

In the present specification, a structural unit containing a silicon atom bonded to four oxygen atoms is referred to as "Q unit".

Also, a structural unit containing a silicon atom in which one oxygen atom among the four oxygen atoms is bonded to another silicon atom is referred to as "Q1 unit". The structural unit represented by the formula (C1) and the structural unit represented by the formula (C1') are Q1 units.

Moreover, a structural unit containing a silicon atom in which two oxygen atoms among the four oxygen atoms are bonded to other silicon atoms is referred to as "Q2 unit". The structural unit represented by the formula (C2) is a Q2 unit.

Further, a structural unit containing a silicon atom in which three oxygen atoms among the four oxygen atoms are bonded to other silicon atoms is referred to as "Q3 unit". The structural unit represented by the formula (C3) is a Q3 unit.

Furthermore, a structural unit containing a silicon atom in which all the four oxygen atoms are bonded to other silicon atoms is referred to as "Q4 unit". The structural unit represented by the formula (C4) is "Q4 unit".

That is, the Q unit means Q1 unit, Q2 unit, Q3 unit, and Q4 unit.

### <<Silicone Resin A>>

The silicone resin contained in the silicone resin composition of the present embodiment is preferably a mixture of a silicone resin (hereinafter referred to as "silicone resin A") as a main agent and an oligomer component described later.

The silicone resin A contains the structural unit represented by the formula (A3). Further, the silicone resin A preferably further contains one or more structural units selected from the group consisting of the structural unit represented by the formula (A1), the structural unit represented by the formula (A1'), and the structural unit represented by the formula (A2).

In the silicone resin A, the total content of the T1 unit, T2 unit and T3 unit to the total content of all structural units of the silicone resin A is usually 70% by mole or more.

In the silicone resin A, the content of the T3 unit to the total content of all structural units of the silicone resin A is usually 60% by mole or more and 90% by mole or less.

The polystyrene equivalent weight average molecular weight of the silicone resin A is usually 1500 or more and 8000 or less.

In the silicone resin A, the total content of the T1 unit, T2 unit and T3 unit to the total content of all structural units of the silicone resin A is preferably 80% by mole or more, more preferably 90% by mole or more, and further preferably 95% by mole or more.

In the silicone resin A, the content of the T3 unit to the total content of all structural units of the silicone resin A is preferably 65% or more and 90% or less, and more preferably 70% or more and 85% or less.

The polystyrene equivalent weight average molecular weight of the silicone resin A is preferably from 1500 or more to 7000 or less, and more preferably from 2000 or more to 5000 or less. When the polystyrene equivalent weight average molecular weight of the silicone resin A is within this range, mixing performance with the phosphor described later is improved.

As the silicone resin A, a commercially available silicone resin can be used.

The silicone resin A preferably has a silanol group (Si-OH). In the silicone resin A, a silicon atom having a silanol group to all silicon atoms contained in the silicone resin A is preferably 1 to 30% by mole, more preferably 5 to 27% by mole, and further preferably 10 to 25% by mole. In the silicone resin A, when the content of the silicon atoms having a silanol group is within the above range, in mixing with the wavelength conversion material described later, hydrogen bonds are formed between the silicone resin A and a surface of the wavelength conversion material. Therefore, mixing performance with the wavelength conversion material is improved. In addition, since a curing reaction of the wavelength conversion material-containing silicone resin composition of the present embodiment easily proceeds, a wavelength conversion sheet with high heat resistance can be obtained.

Further, in the silicone resin A, a silicon atom having an alkoxy group to all silicon atoms contained in the silicone resin A is preferably more than 0% by mole and 20% by mole or less, more preferably more than 0% by mole and 10% by mole or less, and further preferably 1% by mole or more and 10% by mole or less. In the silicone resin A, when the content of the silicon atoms having an alkoxy group is within the above range, storage stability of the silicone resin composition of the present embodiment is good and fluidity is within an appropriate range, thus handling properties of the silicone resin composition is improved.

The silicone resin A can be synthesized using an organosilicon compound having a functional group capable of forming a siloxane bond as a starting material. Here, examples of the "functional group capable of forming a siloxane bond" include a halogen atom, a hydroxyl group, and an alkoxy group. Examples of the organosilicon compound corresponding to the structural unit represented by the formula (A3) include organotrihalosilanes, organotrialkoxysilanes, and the like. The silicone resin A can be synthesized by reacting an organosilicon compound as the starting material in a ratio corresponding to the abundance ratio of each structural unit by a hydrolysis-condensation method, in the presence of an acid such as hydrochloric acid or a base such as sodium hydroxide. By appropriately selecting the organosilicon compound as the starting material, the abundance ratio of T3 silicon atoms contained in the silicone resin A can be adjusted.

The content of the silicone resin A contained in the silicone resin composition of the present embodiment to the total content of all silicone resins contained in the silicone resin composition is preferably 60% by mass to 100% by mass, and more preferably 70 to 95% by mass.

### (Oligomer Component)

The silicone resin contained in the silicone resin composition of the present embodiment may contain an oligomer component, in addition to the silicone resin A. By including the oligomer component in the silicone resin, a cured product of the silicone resin composition of the present embodiment has excellent flexibility and crack resistance.

### <<Oligomer B (First Oligomer)>>

Examples of the oligomer component include oligomers containing a structural unit represented by the following formula (B1), formula (B1'), formula (B2) or formula (B3). 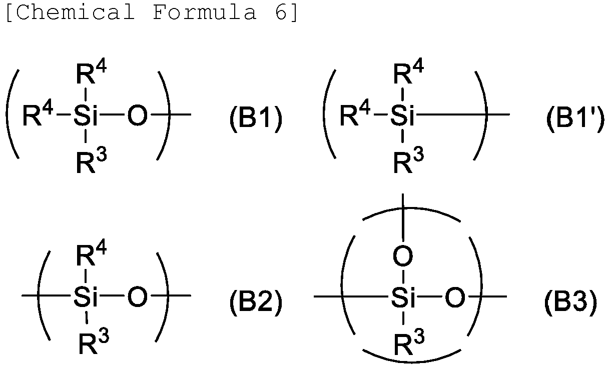 In the formulas (B1), (B1'), (B2) and (B3),
R³ represents an alkyl group having 1 to 10 carbon atoms or an aryl group having 6 to 10 carbon atoms;
R⁴ represents an alkyl group having 1 to 10 carbon atoms, an aryl group having 6 to 10 carbon atoms, an alkoxy group having 1 to 4 carbon atoms or a hydroxyl group; and
a plurality of R³s and R⁴s each may be the same or different.

The polystyrene equivalent weight average molecular weight of the oligomer containing the structural units represented by the formula (B1), the formula (B1'), the formula (B2) and the formula (B3) is preferably 1000 to 10000, more preferably 2000 to 8000, and further preferably 3000 to 6000. When the polystyrene equivalent weight average molecular weight of the oligomer is within this range, mixing performance with the silicone resin A and the oligomer C described later is improved.

In the following description, an oligomer component containing the structural units represented by the formula (B1), the formula (B1'), the formula (B2) and the formula (B3) and having a polystyrene equivalent weight average molecular weight of 1000 to 10000 is referred to as "oligomer B".

The oligomer B is preferably (a) an oligomer containing a T2 unit or (b) an oligomer containing a D unit, and more preferably an oligomer satisfying (a) and (b), that is, (c) an oligomer containing a T2 unit and a D unit. When the silicone resin composition of the present embodiment contains an oligomer satisfying (c), it is easy to prepare a phosphor sheet without wrinkles or cracks.

### (a) Oligomer containing T2 unit

As the oligomer containing a T2 unit (a), one having a content of the structural unit represented by the formula (B2) contained in the first oligomer in which R⁴ is an alkoxy group having 1 to 4 carbon atoms or a hydroxyl group, that is, a content of the T2 unit, of 30 to 60% by mole is preferable, and of 40 to 55% by mole is more preferable.

In the case where the oligomer B is an oligomer containing a T2 unit (a), when the content of the T2 unit is within the above-described range, the silicone resin composition of the present embodiment exhibits good curing reactivity during thermal curing while securing solubility of the silicone resin A and the oligomer B.

### (b) Oligomer containing D unit

As the oligomer containing a D unit (b), a silicone resin containing a structural unit represented by the formula (B1), the formula (B1'), the formula (B2) or the formula (B3) in which the average composition formula is represented by the following formula (I) is preferable.

(R⁵)ₙSi(OR⁶)ₘO_{(4-n-m)/2} ... (I)

In the formula (I),
R⁵ represents an alkyl group having 1 to 10 carbon atoms or an aryl group having 6 to 10 carbon atoms;
R⁶ represents an alkyl group having 1 to 10 carbon atoms, an aryl group having 6 to 10 carbon atoms or a hydrogen atom;
n represents a real number satisfying 1 < n < 2; and m represents a real number satisfying 0 < m < 1.

An oligomer B having an average composition formula represented by the formula (I) contains the "T unit" and "D unit" described above.

In the formula (I), R⁵ is preferably a methyl group, and R⁶ is preferably a methyl group or a hydrogen atom. It is preferable that n is a real number satisfying 1 < n ≤ 1.5 and m is a real number satisfying 0.5 ≤ m < 1, and it is more preferable that n is a real number satisfying 1.1 ≤ n ≤ 1.4 and m is a real number satisfying 0.55 ≤ m ≤ 0.75. When n and m in the formula (I) are within these ranges, compatibility between the oligomer B and the silicone resin A is improved.

Among all structural units contained in the oligomer B, the structural unit represented by the formula (B1) and the structural unit represented by the formula (B1') in which one of two R⁴s is an alkyl group having 1 to 10 carbon atoms or an aryl group having 6 to 10 carbon atoms and the other is an alkoxy group having 1 to 4 carbon atoms or a hydroxyl group is a "D1 unit".

Among all structural units contained in the oligomer B, the structural unit represented by the formula (B2) in which R⁴ is an alkyl group having 1 to 10 carbon atoms or an aryl group having 6 to 10 carbon atoms is a "D2 unit".

In the case where the oligomer B is an oligomer containing a D unit (b), among all structural units contained in the oligomer B, the total content of the D1 unit and the D2 unit is preferably 5 to 80% by mole, more preferably 10 to 70% by mole, and further preferably 15 to 50% by mole.

### (c) Oligomer containing T2 unit and D unit

The oligomer containing a T2 unit and a D unit (c) satisfies requirements of both the oligomer containing a T2 unit (a) and the oligomer containing a D unit (b).

Among all structural units contained in the oligomer B, the structural unit represented by the formula (B1) and the structural unit represented by the formula (B1') in which two R⁴s are an alkoxy group having 1 to 4 carbon atoms or a hydroxyl group is a T1 unit.

Among all structural units contained in the oligomer B, the structural unit represented by the formula (B2) in which R⁴ is an alkoxy group having 1 to 4 carbon atoms or a hydroxyl group is a T2 unit.

Among all structural units contained in the oligomer B, the structural unit represented by the formula (B3) is a T3 unit.

In the case where the oligomer B is an oligomer containing a T2 unit and a D unit (c), among all structural units contained in the oligomer B, the molar ratio of the total content of the T1 unit, the T2 unit and the T3 unit to the content of the D unit (T unit : D unit) is preferably 60 : 40 to 90 : 10, and more preferably 75 : 25 to 85 : 15. When the molar ratio of T unit : D unit is within the above range, compatibility between the silicone resin A and the oligomer B is improved.

The oligomer B corresponds to each of the above-described structural units constituting the silicone resin and can be synthesized using an organosilicon compound having a functional group capable of generating a siloxane bond as a starting material. Here, examples of the "functional group capable of forming a siloxane bond" include a halogen atom, a hydroxyl group, and an alkoxy group.

Examples of the organosilicon compound corresponding to the structural unit represented by the formula (B3) include organotrihalosilanes, organotrialkoxysilanes, and the like. Examples of the organosilicon compound corresponding to the structural unit represented by the formula (B2) include organodihalosilanes, organodialkoxysilanes, and the like.

The oligomer B can be synthesized by reacting an organosilicon compound as the starting material in a ratio corresponding to the abundance ratio of each structural unit by a hydrolysis-condensation method, in the presence of an acid such as hydrochloric acid or a base such as sodium hydroxide. By appropriately selecting the organosilicon compound as the starting material, the abundance ratio of silicon atoms of the T unit and silicon atoms of the D unit contained in the oligomer B can be adjusted.

The content of the oligomer B contained in the silicone resin composition of the present embodiment is to the total content of all silicone resins contained in the silicone resin compositionpreferably 0.1 to 20% by mass, more preferably 0.2 to 15% by mass, and further preferably 0.5 to 10% by mass.

Also, the content of the oligomer B contained in the silicone resin composition of the present embodiment to the content of the silicone resin A contained in the silicone resin composition of the present embodiment is preferably 0.1 to 20% by mass, more preferably 1 to 15% by mass, and further preferably 5 to 12% by mass.

In the molecular weight distribution of the oligomer B measured by a GPC method, single or multiple peaks may exist. In the molecular weight distribution of the oligomer B, the sum of areas of peaks present in a region with a polystyrene equivalent weight average molecular weight of 7500 or more, to the sum of areas of all peaks, may be 20% or more, and the sum of areas of peaks present in a region with a polystyrene equivalent weight average molecular weight of 1000 or less to the sum of areas of all peaks may be 30% or more.

### <<Oligomer C (Second Oligomer)>>

Other examples of the oligomer component include silicone resins containing the structural unit represented by the formula (A1), formula (A1'), formula (A2) or formula (A3) which have the content of the structural unit represented by the formula (A3), to the total content of the structural unit represented by the formula (A1), the structural unit represented by the formula (A1'), the structural unit represented by the formula (A2) and the structural unit represented by the formula (A3), of from 0 to 30% by mole and which have the polystyrene equivalent weight average molecular weight is less than 1500.

In the following description, such silicone resin is referred to as "oligomer C".

The oligomer C is a silicone resin containing one or more structural units of the structural unit represented by the formula (A1), the structural unit represented by the formula (A1'), the structural unit represented by the formula (A2) and the structural unit represented by the formula (A3), and may be a silicone resin containing all four structural units.

The oligomer C is a silicone resin having a ratio of the content of the T3 silicon atoms to the total content of the T1 silicon atoms, the T2 silicon atoms and the T3 silicon atoms of 0 to 30% by mole, and a polystyrene equivalent weight average molecular weight of less than 1500. The ratio of the content of the T3 silicon atoms to the total content of the T1 silicon atoms, the T2 silicon atoms and the T3 silicon atoms is preferably 0 to 25% by mole.

Preferably, the oligomer C is substantially free of an alkenyl group and a hydrosilyl group. That is, it is preferable that the oligomer C does not have an alkenyl group and a hydrogen atom, as R² in the structural unit represented by the formula (A1), the structural unit represented by the formula (A1'), the structural unit represented by the formula (A2), and the structural unit represented by the formula (A3). When the oligomer C has an alkenyl group or a hydrosilyl group, the cured product of the silicone resin composition of the present embodiment has low heat resistance.

The oligomer C is preferably an oligomer having an organopolysiloxane structure represented by the following formula (2). 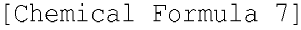 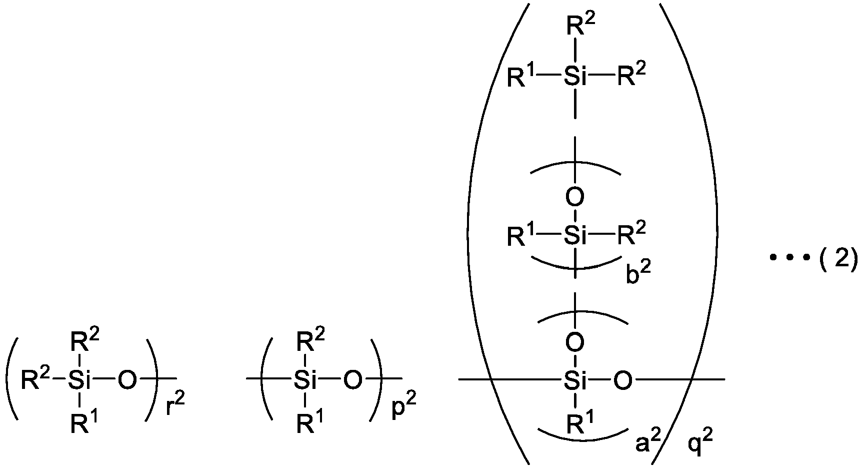 In the formula (2),
R¹ and R² have the same meaning as described above, a plurality of R¹s and R²s each may be the same or different, and
p2, q², r², a² and b² represent any numbers equal to or greater than 0 such that [a² × q²] / [(p2 + b² × q²) + a² × q² + (r² + q²)] = 0 to 0.3.

In the organopolysiloxane structure represented by the formula (2), it is preferable that R¹ is one or more groups selected from the group consisting of a methyl group, an ethyl group and a phenyl group, and R² is one or more groups selected from the group consisting of a methoxy group, an ethoxy group, an isopropoxy group and a hydroxyl group, and it is more preferable that R¹ is one or more groups selected from the group consisting of a methyl group and an ethyl group, and R² is one or more groups selected from the group consisting of a methoxy group, an ethoxy group and an isopropoxy group. In particular, from the viewpoint of heat resistance of the cured product of the silicone resin composition of the present embodiment, R¹ is preferably a methyl group.

The abundance ratio of each structural unit of the oligomer C having the organopolysiloxane structure represented by the formula (2) can be represented by the abundance ratio of the T1 silicon atoms, the T2 silicon atoms, and the T3 silicon atoms. That is, T1 silicon atoms : T2 silicon atoms : T3 silicon atoms = [r² + q²] : [p² + b² × q²] : [a² × q²]. The abundance ratio of each silicon atom in the oligomer C can be adjusted by appropriately adjusting the numerical values of p², q², r², a² and b². For example, when at least one of a² and q² is 0, a T3 silicon atom is not present in the oligomer C, and only linear or cyclic molecules are contained. On the other hand, when both r² and q² are 0, only T2 silicon atoms are present in the oligomer C and only cyclic molecules are contained.

In the organopolysiloxane structure represented by the formula (2), when the number of T2 silicon atoms is x₂, the number of T3 silicon atoms is y₂, and the number of T1 silicon atoms is z₂, the abundance ratio of the T3 silicon atoms in the organopolysiloxane structure represented by the formula (2) is represented by [y₂/ (x₂ + y₂ + z₂)].

[a² × q²] / [(p² + b² × q²) + a² × q² + (r² + q2)] is equal to the abundance ratio of the T3 silicon atoms in the organopolysiloxane structure represented by the formula (2) : [y₂/(x₂ + y₂ + z₂)]. That is, p², q², r², a² and b² in the formula (2) are appropriately adjusted so that the abundance ratio of the T3 silicon atoms is within the range of 0 to 0.3.

The oligomer C, which may be contained in the silicone resin composition of the present embodiment, is a silicone resin having an organopolysiloxane structure represented by the formula (2), and is preferably an oligomer having a ratio of the content of the T3 silicon atoms to the total content of the T1 silicon atoms, the T2 silicon atoms and the T3 silicon atoms: [y₂/(x₂ + y₂ + z₂)] of 0 to 0.3, and a polystyrene equivalent weight average molecular weight of less than 1500. When the abundance ratio of the T3 silicon atoms is within this range, the abundance ratio of the T2 silicon atoms: [x₂/(x₂ + y₂ + z₂)] and the abundance ratio of the T1 silicon atoms: [z₂/(x₂ + y₂ + z₂)] are not particularly limited. As the oligomer C, one having [y₂/(x₂ + y₂ + z₂)] within the range of 0 to 0.25 is preferable, and within the range of 0.05 to 0.2 is more preferable.

The oligomer C has a relatively low abundance ratio of the T3 silicon atoms, and thus contains few branched chain structures and many linear or cyclic molecules. The oligomer C may contain only cyclic molecules, but preferably contains many linear molecules. As the oligomer C, for example, one in which the abundance ratio of the T1 silicon atoms: [z₂/(x₂ + y₂ + z₂)] is within the range of 0 to 0.80, more preferably within the range of 0.30 to 0.80, further preferably within the range of 0.35 to 0.75, and particularly preferably within the range of 0.35 to 0.55.

The content of the oligomer C contained in the silicone resin composition of the present embodiment to the total content of all silicone resins contained in the silicone resin composition is preferably 0.1 to 20% by mass, more preferably 0.2 to 15% by mass, and further preferably 0.5 to 10% by mass.

Also, the content of the oligomer C contained in the silicone resin composition of the present embodiment to the content of the silicone resin A contained in the silicone resin composition of the present embodiment is preferably 0.1 to 20% by mass, more preferably 0.3 to 10% by mass, and further preferably 0.5 to 5% by mass.

The polystyrene equivalent weight average molecular weight of the oligomer C measured by the GPC method is less than 1500. When the polystyrene equivalent weight average molecular weight of the oligomer C is too large, crack resistance of the cured product of the silicone resin composition of the present embodiment may be insufficient in some cases. The polystyrene equivalent weight average molecular weight of the oligomer C may be less than 1000.

The number of T1 silicon atoms, T2 silicon atoms and T3 silicon atoms in one molecule of the oligomer C is appropriately adjusted so that the resin having the organopolysiloxane structure represented by the formula (2) has a desired molecular weight. In one embodiment, the sum of the number of T1 silicon atoms, the number of T2 silicon atoms and the number of T3 silicon atoms in one molecule of the oligomer C is preferably 2 or more.

The oligomer C corresponds to each of the above-described structural units constituting the oligomer C and can be synthesized using an organosilicon compound having a functional group capable of generating a siloxane bond as a starting material. Here, the "functional group capable of forming a siloxane bond" has the same meaning as one described above. Examples of the organosilicon compound corresponding to the structural unit represented by the formula (A3) include organotrihalosilanes, organotrialkoxysilanes, and the like. The oligomer C can be synthesized by reacting such organosilicon compound as the starting material in a ratio corresponding to the abundance ratio of each structural unit by a hydrolysis-condensation method.

Upon synthesis of the oligomer C, an organosilicon compound corresponding to the structural unit represented by the formula (A1) and an organosilicon compound corresponding to the structural unit represented by the formula (A1') are mixed as the starting material. When these organosilicon compounds are polymerized by hydrolysis condensation reaction, the organosilicon compounds are bound to the end of the polymerization reaction to stop the polymerization reaction.

The silicone resin composition of the present embodiment preferably contains the silicone resin A and the oligomer B or the oligomer C, and more preferably contains the silicone resin A, the oligomer B, and the oligomer C.

### (Solvent)

Since the silicone resin composition of the present embodiment has high content of the T3 unit, a solvent is contained for the purpose of achieving good coating properties. The solvent is not particularly limited as long as it can dissolve the silicone resin. As the solvent, for example, two or more kinds of solvents having different boiling points (hereinafter referred to as "solvent P" and "solvent Q") can be used.

As the solvent P, an organic solvent having a boiling point of lower than 100°C is preferable. Specifically, ketone solvents such as acetone and methyl ethyl ketone; alcohol solvents such as methanol, ethanol, isopropyl alcohol and normal propyl alcohol; hydrocarbon solvents such as hexane, cyclohexane, heptane and benzene; ester acetate solvents such as ethyl acetate; and ether solvents such as diethyl ether and tetrahydrofuran are preferable.

Among them, alcohol solvents such as methanol, ethanol, isopropyl alcohol and normal propyl alcohol are more preferable as the solvent P.

As the solvent Q, an organic solvent having a boiling point of 100°C or more is preferable. Specifically, glycol ether solvents and glycol ester solvents are preferable.

Specific examples of the glycol ether solvents include ethylene glycol monomethyl ether, ethylene glycol monoethyl ether, ethylene glycol monoisopropyl ether, ethylene glycol monobutyl ether, ethylene glycol monohexyl ether, ethylene glycol monoethylhexyl ether, ethylene glycol monophenyl ether, ethylene glycol monobenzyl ether, diethylene glycol monomethyl ether, diethylene glycol monoethyl ether, diethylene glycol monoisopropyl ether, diethylene glycol monobutyl ether, diethylene glycol monohexyl ether, diethylene glycol monoethylhexyl ether, diethylene glycol monophenyl ether, diethylene glycol monobenzyl ether, propylene glycol monomethyl ether, propylene glycol monoethyl ether, propylene glycol monoisopropyl ether, propylene glycol monobutyl ether, propylene glycol monohexyl ether, propylene glycol monoethylhexyl ether, propylene glycol monophenyl ether, propylene glycol monobenzyl ether, dipropylene glycol monomethyl ether, dipropylene glycol monoethyl ether, dipropylene glycol monoisopropyl ether, dipropylene glycol monobutyl ether, dipropylene glycol monohexyl ether, dipropylene glycol monoethylhexyl ether, dipropylene glycol monophenyl ether, and dipropylene glycol monobenzyl ether.

Specific examples of the glycol ester solvents include ethylene glycol monoethyl ether acetate, ethylene glycol monoisopropyl ether acetate, ethylene glycol monobutyl ether acetate, ethylene glycol monohexyl ether acetate, ethylene glycol monoethylhexyl ether acetate, ethylene glycol monophenyl ether acetate, and ethylene glycol monobenzyl ether acetate.

Among them, ethylene glycol monobutyl ether, diethylene glycol monobutyl ether, dipropylene glycol monomethyl ether and ethylene glycol monobutyl ether acetate are more preferable as the solvent Q.

In the silicone resin composition of the present embodiment, the content of the solvent to the total content of all components contained in the silicone resin composition is usually 5 to 60% by mass, preferably 10 to 40% by mass, and more preferably 15 to 35% by mass. Since the silicone resin composition of the present embodiment is a liquid composition having a viscosity of 100 to 50000 mPa·s at 25°C, it has good coating properties. Also, even when the silicone resin composition of the present embodiment further contains a wavelength conversion material to be described later, coating properties can be easily adjusted. The viscosity of the silicone resin composition can be measured, for example, by a cone-plate type E type viscometer, by a method of detecting resistance (viscous resistance) that the cone plate receives from a fluid by rotational torque.

### (Silicone Resin Composition)

### <<Mixing Ratio>>

The silicone resin composition of the present embodiment is obtained by mixing the silicone resin A, the solvent, and optionally the oligomer B, the oligomer C or other components. The silicone resin composition of the present embodiment preferably contains the silicone resin A, the solvent, the oligomer B, and the oligomer C. Here, it is preferable to mix the oligomer B in an amount smaller than the silicone resin A and the oligomer C in an amount smaller than the silicone resin A, to the silicone resin A. In the silicone resin composition of the present embodiment, the mixing ratio of the silicone resin A, the oligomer B and the oligomer C is preferably silicone resin A : oligomer B : oligomer C = 100 : 0.1 to 20 : 0.1 to 20 (mass ratio), from the viewpoint of coating properties and heat resistance of the cured product after curing.

In the silicone resin composition of the present embodiment, the mixing ratio of the silicone resin is more preferably silicone resin A: oligomer B: oligomer C = 100 : 0.2 to 15 : 0.2 to 15 (mass ratio), and still more preferably silicone resin A : oligomer B : oligomer C = 100 : 1 to 10 : 1 to 10 (mass ratio).

### <<Method for Producing Silicone Resin Composition>>

The mixing method of the silicone resin A, the oligomer B and the oligomer C is not particularly limited, and any of known methods performed when mixing two or more types of polymers may be used. For example, each of the silicone resin A, the oligomer B, the oligomer C and optionally other components may be dissolved in an organic solvent, and then the obtained solution may be mixed.

The silicone resin can be more uniformly mixed and stability of the prepared silicone resin composition can be improved. Therefore, it is preferable that the silicone resin is dissolved in a highly volatile and highly soluble organic solvent, and then the organic solvent is replaced with another solvent.

Specifically, first, the silicone resin A is added to a highly volatile and highly soluble organic solvent (for example, the solvent P), then the mixture is heated to a temperature near the boiling point of the solvent P and stirred to dissolve the silicone resin A.

Next, the oligomer B, the oligomer C and optionally other components are added to the obtained solution, and then the oligomer B, the oligomer C and optionally other components are dissolved in the solvent P by the same method as described above.

Next, a solvent having a lower volatility than the solvent P (for example, the solvent Q) is added to the obtained solution, and then the mixture was heated and distilled until the concentration of the solvent P becomes 1% or less, whereby the solvent P can be replaced with the solvent Q. In order to efficiently perform solvent replacement, heating distillation may be performed under reduced pressure.

Residual solvents, water and the like that can be contained in each of the silicone resin A, the oligomer B, the oligomer C and other components can be removed by performing solvent replacement. Therefore, by solvent replacement, stability of the silicone resin composition can be improved.

### (Other Components)

In addition to the silicone resin and the solvent, the silicone resin composition of the present embodiment may contain other components such as a curing catalyst, a silane coupling agent, inorganic particles, a dispersant, a leveling agent, a defoaming agent, and the like.

### (Silane Coupling Agent)

Examples of the silane coupling agent include silane coupling agents having at least one or more selected from the group consisting of a vinyl group, an epoxy group, a styryl group, a methacryl group, an acryl group, an amino group, an ureido group, a mercapto group, a sulfide group, and an isocyanate group. Among them, a silane coupling agent having an epoxy group or a mercapto group is preferable.

Specific examples of the silane coupling agent include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, 3-mercaptopropylmethyldimethoxysilane, and 3-mercaptopropyltrimethoxysilane.

The content of the silane coupling agent to 100 parts by mass of the silicone resin contained in the silicone resin composition of the present embodiment is usually 0.0001 to 1.0 part by mass, and preferably 0.001 to 0.1 parts by mass.

### (Inorganic Particles)

Examples of the inorganic particles to be added other than the wavelength conversion material include oxides such as silicon, titanium, zirconia, aluminum, iron and zinc; carbon black, barium titanate, calcium silicate, calcium carbonate, and the like. Among them, oxides such as silicon, titanium, zirconia, and aluminum are more preferable as the inorganic particles.

Examples of the shape of the inorganic particles include a substantially spherical shape, a plate shape, a column shape, a needle shape, a whisker shape and a fibrous shape, and a substantially spherical shape is preferable since a more uniform resin composition is obtained.

The silicone resin composition of the present embodiment may contain only one type of inorganic particles or two or more types of inorganic particles, but it is preferable that the inorganic particles are two or more types of inorganic particles having different particle sizes. It is more preferable that the silicone resin composition of the present embodiment includes inorganic particles with an average particle diameter of primary particles of 100 to 500 nm and inorganic particles with an average particle diameter of primary particles of less than 100 nm. In the wavelength conversion material-containing silicone resin composition described later, excitation efficiency of the wavelength conversion material due to scattering of light is improved by including two or more types of inorganic particles having different average particle sizes of primary particles, and sedimentation of the wavelength conversion material is suppressed.

The average particle size of primary particles of the inorganic particles can be determined, for example, by imaging method in which particles are directly observed with an electron microscope or the like.

Specifically, first, a liquid in which inorganic particles to be measured are dispersed in an any solvent is prepared, and the obtained dispersion is dropped on a slide glass or the like and dried. It may be prepared by directly spraying the inorganic particles on an adhesive surface of an adhesive tape to adhere the inorganic particles to the tape.

Next, the particles are directly observed with a scanning electron microscope (SEM) or a transmission electron microscope (TEM), and the dimension of the inorganic particles is determined from the obtained shape to determine the average particle size of primary particles of the inorganic particles.

The content of the inorganic particles to 100 parts by mass of the silicone resin contained in the silicone resin composition of the present embodiment is preferably 0.01 to 100 parts by mass and more preferably 0.1 to 50 parts by mass.

The silicone resin composition of the present embodiment contains a silicone resin A, a solvent, and optionally an oligomer component or other components, and is a liquid composition having a viscosity of 100 to 50000 mPa·s at 25°C. As described later in the examples, the silicone resin composition of the present embodiment has good coating properties, and the cured product after curing has excellent heat resistance.

### (Curing Catalyst)

As the curing catalyst, for example, when R² in the structural unit represented by the formula (A1), the structural unit represented by the formula (A1') and the structural unit represented by the formula (A2) is an alkoxy group or a hydroxyl group, an inorganic acid such as hydrochloric acid, sulfuric acid, nitric acid, phosphoric acid or phosphoric acid ester; or an organic acid such as formic acid, acetic acid, oxalic acid, citric acid, propionic acid, butyric acid, lactic acid or succinic acid can be used, in order to accelerate hydrolysis condensation reaction.

As the curing catalyst, not only an acidic compound but also an alkaline compound can be used. Specifically, ammonium hydroxide, tetramethylammonium hydroxide, tetraethylammonium hydroxide or the like can be used as the curing catalyst.

As the curing catalyst, an organometallic compound catalyst can also be used. Specifically, as the curing catalyst, an organometallic compound catalyst containing aluminum, zirconium, tin, titanium or zinc can be used.

Examples of the organometallic compound catalyst containing aluminum include aluminum triacetylacetate and aluminum triisopropoxide.

Examples of the organometallic compound catalyst containing zirconium include zirconium tetraacetylacetonate, zirconium tributoxyacetylacetonate, zirconium dibutoxydiacetylacetonate, zirconium tetranormalbutoxide, zirconium tetraisopropoxide, zirconium tetranormalbutoxide, zirconium acylate, and zirconium tributoxystearate.

Examples of the organometallic compound catalyst containing tin include tetrabutyltin, monobutyltin trichloride, dibutyltin dichloride, dibutyltin oxide, tetraoctyltin, dioctyltin dichloride, dioctyltin oxide, tetramethyltin, dibutyltin laurate, dioctyltin dilaurate, bis(2-ethylhexanoate)tin, bis(neodecanoate)tin, di-n-butylbis(ethylhexylmalate)tin, di-normalbutylbis(2,4-pentanedionate)tin, di-normalbutyl butoxy chlorotin, di-normalbutyl diacetoxytin, di-normalbutyltin dilaurate, and dimethyltin dineodecanoate.

Examples of the organometallic compound catalyst containing titanium include titanium tetraisopropoxide, titanium tetranormalbutoxide, butyl titanate dimer, tetraoctyl titanate, titanium acetylacetonate, titanium octylene glycolate, and titanium ethyl acetoacetate.

Examples of the organometallic compound catalyst containing zinc include zinc triacetylacetonate.

Among them, phosphoric acid ester or phosphoric acid is preferable, and phosphoric acid is more preferable, from the viewpoint of transparency of the obtained cured product.

In order to add the curing catalyst to the silicone resin composition at a predetermined concentration, it is preferable to dilute the curing catalyst into water, an organic solvent, a silicone-based monomer, an alkoxysilane oligomer or the like and then add it to the silicone resin composition.

The content of the curing catalyst can be appropriately adjusted in consideration of the heating temperature and time of the curing reaction of the silicone resin composition, the type of catalyst, and the like. The content of the curing catalyst is preferably 0.01 to 10 parts by mass, more preferably 0.01 to 5 parts by mass, and further preferably 0.1 to 1 part by mass, with regard to 100 parts by mass of the silicone resin composition of the present embodiment.

The curing catalyst may be added to the silicone resin composition beforehand or may be added to the silicone resin immediately before performing the curing reaction of the silicone resin composition.

### <Wavelength Conversion Material-Containing Silicone Resin Composition>

The wavelength conversion material-containing silicone resin composition of the present embodiment includes the above-described silicone resin composition and a wavelength conversion material.

The wavelength conversion material-containing silicone resin composition of the present embodiment is preferably a liquid composition having a viscosity of 1000 to 500000 mPa·s, more preferably a liquid composition having a viscosity of 8000 to 100000 mPa·s, and further preferably a liquid composition having a viscosity of 10000 to 80000 mPa·s at 25°C. When the viscosity of the wavelength conversion material-containing silicone resin composition at 25°C is within these ranges, coating properties are improved.

### (Wavelength Conversion Material)

Examples of the wavelength conversion material include a phosphor and a quantum dot. Examples of the phosphor include red phosphors emitting fluorescence in the wavelength range of 570 nm to 700 nm, yellow phosphors emitting fluorescence in the range of 530 nm to 620 nm, green phosphors emitting fluorescence in the range of 490 nm to 570 nm, and blue phosphors emitting fluorescence in the range of 420 to 480 nm. Only one type of phosphor may be used alone, or two or more types thereof may be used in combination.

### <<Red Phosphor>>

Examples of the red phosphor include europium-activated alkaline earth silicon nitride phosphors expressed by (Mg,Ca,Sr,Ba)₂Si₅N₈:Eu, which are composed of broken particles having red broken surfaces, and europium-activated rare-earth oxychalcogenide phosphors expressed by (Y,La,Gd,Lu)₂O₂S:Eu, which are composed of grown particles having a nearly spherical shape as the regular crystal growth shape.

Examples of other red phosphor include phosphors containing an oxynitride and/or oxysulfide containing at least one element selected from the group consisting of Ti, Zr, Hf, Nb, Ta, W and Mo and containing an oxynitride having an alpha-sialon structure in which part or all of Al elements are substituted with Ga elements.

Other examples of the red phosphor include Eu-activated oxysulfide phosphors such as (La,Y)₂O₂S:Eu; Eu-activated oxide phosphors such as Y(V,P)O₄:Eu and Y₂O₃:Eu; Eu,Mn-activated silicate phosphors such as (Ba,Sr,Ca,Mg)₂SiO₄:Eu,Mn and (Ba,Mg)₂SiO₄:Eu,Mn; Eu-activated sulfide phosphors such as (Ca,Sr)S:Eu; Eu-activated aluminate phosphors such as YAlO₃:Eu; Eu-activated silicate phosphors such as LiY₉(SiO₄)₆O₂:Eu, Ca₂Y₈(SiO₄)₆O₂:Eu, (Sr,Ba,Ca)₃SiO₅:Eu and Sr₂BaSiO₅:Eu; Ce-activated aluminate phosphors such as (Y,Gd)₃Al₅O₁₂:Ce and (Tb,Gd)₃Al₅O₁₂:Ce; Eu-activated nitride phosphors such as (Ca,Sr,Ba)₂Si₅N₈:Eu, (Mg,Ca,Sr,Ba)SiN₂:Eu and (Mg,Ca,Sr,Ba)AlSiN₃:Eu; Ce-activated nitride phosphors such as (Mg,Ca,Sr,Ba)AlSiN₃:Ce; Eu,Mn-activated halophosphate phosphors such as (Sr,Ca,Ba,Mg)₁₀(PO₄)₆Cl₂:Eu,Mn; Eu,Mn-activated silicate salt phosphors such as (Ba₃Mg)Si₂O₈:Eu,Mn and (Ba,Sr,Ca,Mg)₃(Zn,Mg)Si₂O₈:Eu,Mn; Mn-activated germanate phosphors such as 3.5MgO · 0.5MgF₂ · GeO₂:Mn; Eu-activated oxynitride phosphors such as Eu-activated α sialon; Eu,Bi-activated oxide phosphors such as (Gd,Y,Lu,La)₂O₃:Eu,Bi; Eu,Bi-activated oxysulfide phosphors such as (Gd,Y,Lu,La)₂O₂S:Eu,Bi; Eu,Bi-activated vanadate phosphors such as (Gd,Y,Lu,La)VO₄:Eu,Bi; Eu,Ce-activated sulfide phosphors such as SrY₂S₄:Eu,Ce; Ce-activated sulfide phosphors such as CaLa₂S₄:Ce; Eu,Mn-activated phosphate phosphors such as (Ba,Sr,Ca)MgP₂O₇:Eu,Mn and (Sr,Ca,Ba,Mg,Zn)₂P₂O₇:Eu,Mn; Eu,Mo-activated tungstate phosphors such as (Y,Lu)₂WO₆:Eu,Mo; Eu, Ce-activated nitride phosphors such as (Ba,Sr,Ca)ₓSi_{y}N_{z}:Eu,Ce (wherein x, y, and z are integers of 1 or more); Eu,Mn-activated halophosphate phosphors such as (Ca,Sr,Ba,Mg)₁₀(PO₄)₆(F,Cl,Br,OH):Eu,Mn; and Ce-activated silicate phosphors such as ((Y,Lu,Gd,Tb)₁₋ₓScₓCe_{y})₂(Ca,Mg)₁₋ᵣ(Mg,Zn)₂₊ᵣSi_{z-q}Ge_{q}O_{12+δ}.

Other examples of the red phosphor include red organic phosphors composed of a rare earth element ion complex containing an anion such as β-diketonate, β-diketone, aromatic carboxylic acid or Bronsted acid, as a ligand, perylene pigments (for example, dibenzo{[f,f']-4,4',7,7'-tetraphenyl}diindeno[1,2,3-cd:1',2',3'-lm]perylene), anthraquinone pigments, lake pigments, azo pigments, quinacridone pigments, anthracene pigments, isoindoline pigments, isoindolinone pigments, phthalocyanine pigments, triphenylmethane basic dyes, indanthrone pigments, indophenol pigments, cyanine pigments, and dioxazine pigments.

Among the red phosphors, a red phosphor having a peak wavelength of fluorescence emission of 580 nm or more and preferably 590 nm or more, and a peak wavelength of fluorescence emission of 620 nm or less and preferably 610 nm or less is suitably used as an orange phosphor. Examples of such orange phosphor include (Sr,Ba)₃SiO₅:Eu, (Sr,Mg)₃PO₄)₂:Sn²⁺, and SrCaAlSiN₃:Eu.

### <<Yellow Phosphor>>

Examples of the yellow phosphor include oxide-based, nitride-based, oxynitride-based, sulfide-based and oxysulfide-based phosphors. Specific examples include garnet-based phosphors having a garnet structure represented by RE₃M₅O₂:Ce (wherein RE represents at least one element selected from the group consisting of Y, Tb, Gd, Lu and Sm, and M represents at least one element selected from the group consisting of Al, Ga and Sc), M²₃M³₂M⁴₃O₁₂:Ce (wherein M² represents a divalent metal element, M³ represents a trivalent metal element, and M⁴ represents a tetravalent metal element) or the like; orthosilicate-based phosphors represented by AE₂M⁵O₄:Eu (wherein AE represents at least one element selected from the group consisting of Ba, Sr, Ca, Mg and Zn, and M⁵ represents at least one element selected from the group consisting of Si and Ge) or the like; oxynitride-based phosphors where a part of oxygen atoms as a constituent element of these phosphors is substituted with a nitrogen atom; and phosphors activated by Ce such as nitride-based phosphors having a CaAlSiN₃ structure such as AEAlSiN₃:Ce (wherein AE represents at least one element selected from the group consisting of Ba, Sr, Ca, Mg and Zn).

Examples of other yellow phosphors include phosphors activated by Eu such as sulfide-based phosphors such as CaGa₂S₄:Eu(Ca,Sr)Ga₂S₄:Eu and (Ca,Sr) (Ga,Al)₂S₄:Eu; and oxynitride-based phosphors having a SiAlON structure such as Caₓ(Si,Al)₁₂(O,N)₁₆:Eu.

### <<Green Phosphor>>

Examples of the green phosphor include europium-activated alkaline earth silicon oxynitride-based phosphors represented by (Mg,Ca,Sr,Ba)Si₂O₂N₂:Eu, which are composed of broken particles having broken surfaces, and europium-activated alkaline earth silicate-based phosphors represented by (Ba,Ca,Sr,Mg)₂SiO₄:Eu, which are composed of broken particles having broken surfaces.

Other examples of the green phosphor include Eu-activated aluminate phosphors such as Sr₄Al₁₄O₂₅:Eu and (Ba,Sr,Ca)Al₂O₄:Eu; Eu-activated silicate salt phosphors such as (Sr,Ba)Al₂Si₂O₈:Eu, (Ba,Mg)₂SiO₄:Eu, (Ba,Sr,Ca,Mg)₂SiO₄:Eu and (Ba,Sr,Ca)₂(Mg,Zn)Si₂O₇:Eu; Ce,Tb-activated silicate phosphors such as Y₂SiO₅:Ce,Tb; Eu-activated borate phosphate phosphors such as Sr₂P₂O-Sr₂B₂O₅:Eu; Eu-activated halosilicate phosphors such as Sr₂Si₃O₈-2SrCl₂:Eu; Mn-activated silicate phosphors such as Zn₂SiO₄:Mn; Tb-activated aluminate phosphors such as CeMgAl₁₁O₁₉:Tb and Y₃Al₅O₁₂:Tb; Tb-activated silicate phosphors such as Ca₂Y₈(SiO₄)₆O₂:Tb and La₃Ga₅SiO₁₄:Tb; Eu,Tb,Sm-activated thiogallate phosphors such as (Sr,Ba,Ca)Ga₂S₄:Eu,Tb,Sm; Ce-activated aluminate phosphors such as Y₃(Al,Ga)₅O₁₂:Ce and (Y,Ga,Tb,La,Sm,Pr,Lu)₃(Al,Ga)₅O₁₂:Ce; Ce-activated silicate phosphors such as Ca₃Sc₂Si₃O₂:Ce and Ca₃(Sc,Mg,Na,Li)₂Si₃O₁₂:Ce; Ce-activated oxide phosphors such as CaSc₂O₄:Ce; Eu-activated oxynitride phosphors such as SrSi₂O₂N₂:Eu, (Sr,Ba,Ca)Si₂O₂N₂:Eu, Eu-activated β-sialon and Eu-activated α-sialon; Eu,Mn-activated aluminate phosphors such as BaMgAl₁₀O₁₇:Eu,Mn; Eu-activated aluminate phosphors such as SrAl₂O₄:Eu; Tb-activated oxysulfide phosphors such as (La,Gd,Y)₂O₂S:Tb; Ce,Tb-activated phosphate phosphors such as LaPO₄:Ce,Tb; sulfide phosphors such as ZnS:Cu,Al and ZnS:Cu,Au,Al; Ce,Tb-activated borate phosphors such as (Y,Ga,Lu,Sc,La)BO₃:Ce,Tb, Na₂Gd₂B₂O₇:Ce,Tb and (Ba,Sr)₂(Ca,Mg,Zn)B₂O₆:K,Ce,Tb; Eu,Mn-activated halosilicate phosphors such as Ca₈Mg(SiO₄)₄Cl₂:Eu,Mn; Eu-activated thioaluminate phosphors or thiogallate phosphors such as (Sr,Ca,Ba) (Al,Ga,In)₂S₄:Eu, and Eu,Mn-activated halosilicate phosphors such as (Ca,Sr)₈(Mg,Zn)(SiO₄)₄Cl₂:Eu,Mn.

Other examples of the green phosphor include pyridine-phthalimide condensation derivatives, benzoxazinone-based, quinazolinone-based, coumarin-based, quinophthalone-based and naphthalimide-based fluorescent dyes; and organic phosphors such as terbium complexes having hexyl salicylate as a ligand.

### <<Blue Phosphor>>

Examples of the blue phosphor include europium-activated barium magnesium aluminate-based phosphors represented by BaMgAl₁₀O₁₇:Eu, which are composed of grown particles having a nearly hexagonal shape as the regular crystal growth shape, europium-activated calcium halophosphate-based phosphors represented by (Ca,Sr,Ba)₅(PO₄)₃Cl:Eu, which are composed of grown particles having a nearly spherical shapes as the regular crystal growth shape, europium-activated alkaline earth chloroborate-based phosphors represented by (Ca,Sr,Ba)₂B₅O₉Cl:Eu, which are composed of grown particles having a nearly cubic shapes as the regular crystal growth shape, and europium-activated alkaline earth aluminate-based phosphors represented by (Sr,Ca,Ba)Al₂O₄:Eu or (Sr,Ca,Ba)₄Al₁₄O₂₅:Eu, which are composed of broken particles having broken surfaces.

Other examples of the blue phosphor include Sn-activated phosphate phosphors such as Sr₂P₂O₇:Sn; Eu-activated aluminate phosphors such as Sr₄Al₁₄O₂₅:Eu, BaMgAl₁₀O₁₇:Eu and BaAl₈O₁₃:Eu; Ce-activated thiogallate phosphors such as SrGa₂S₄:Ce and CaGa₂S₄:Ce; Eu-activated aluminate phosphors such as (Ba,Sr,Ca)MgAl₁₀O₁₇: Eu and BaMgAl₁₀O₁₇:Eu,Tb,Sm; Eu,Mn-activated aluminate phosphors such as (Ba,Sr,Ca)MgAl₁₀O₁₇:Eu,Mn; Eu-activated halophosphate phosphors such as (Sr,Ca,Ba,Mg)₁₀(PO₄)₆Cl₂:Eu and (Ba,Sr,Ca)₅(PO₄)₃(Cl,F,Br,OH):Eu,Mn,Sb; Eu-activated silicate phosphors such as BaAl₂Si₂O₈:Eu and (Sr,Ba)₃MgSi₂O₈:Eu; Eu-activated phosphate phosphors such as Sr₂P₂O₇:Eu; sulfide phosphors such as ZnS:Ag and ZnS:Ag,Al; Ce-activated silicate phosphors such as Y₂SiO₅:Ce; tungstate phosphors such as CaWO₄; Eu,Mn-activated borate phosphate phosphors such as (Ba,Sr,Ca)BPOs:Eu,Mn, (Sr,Ca)₁₀(PO₄)₆ · nB₂O₃:Eu and 2SrO · 0.84P₂O₅ · 0.16B₂O₃:Eu; and Eu-activated halosilicate phosphors such as Sr₂Si₃O · 2SrCl₂:Eu.

Other examples of the blue phosphor include fluorescent dyes such as naphthalimide-based compounds, benzoxazole-based compounds, styryl-based compounds, coumarin-based compounds, pyralizone-based compounds and triazole-based compounds; organic phosphors such as thulium complexes; and the like.

### <<Quantum Dot>>

Examples of the quantum dots include InAs-based quantum dots, and CdE (E = S, Se, Te)-based quantum dots (CdSₓSe₁₋ₓ/ZnS, and the like) .

In the wavelength conversion material-containing silicone resin composition of the present embodiment, the content of the wavelength conversion material, to the total content of all components contained in the wavelength conversion material-containing silicone resin composition, may be 40% by mass or more. The upper limit of the content of the wavelength conversion material to the total content of all components contained in the wavelength conversion material-containing silicone resin composition is, for example, 95% by mass.

Since the wavelength conversion material-containing silicone resin composition of the present embodiment is a liquid composition having a viscosity of 1000 to 500000 mPa·s at 25°C, it has good coating properties. Therefore, the wavelength conversion material-containing silicone resin composition of the present embodiment can be easily applied on a substrate by, for example, an applicator, a slit die coater, or screen printing.

The cured product of the wavelength conversion material-containing silicone resin composition of the present embodiment is suitable for use as, for example, a material for forming a wavelength conversion material-containing sheet for laser diode and a material for forming a wavelength conversion material-containing sheet for LED.

### <Wavelength Conversion Material-Containing Sheet>

The wavelength conversion material-containing sheet (hereinafter sometimes referred to as "wavelength conversion sheet") of the present embodiment uses a cured product of the wavelength conversion material-containing silicone resin composition of the present embodiment as a forming material.

The wavelength conversion sheet of the present embodiment can be suitably used for wavelength conversion sheets for LEDs, solar cells, laser diodes, photodiodes, CCDs, CMOS, and the like. In particular, since the wavelength conversion sheet of the present embodiment has excellent heat resistance, it can be suitably used for a wavelength conversion sheet for a light emitting portion of laser diode requiring heat resistance.

The wavelength conversion sheet of the present embodiment may contain the above-described inorganic particles. By including the inorganic particles in the wavelength conversion sheet of the present embodiment, it is possible to effectively excite the wavelength conversion material by scattering light in the wavelength conversion sheet. In addition, it is possible to suppress sedimentation of the wavelength conversion material in the silicone resin composition at the stage of producing the wavelength conversion sheet of the present embodiment.

### (Film Thickness)

The thickness (film thickness) of the wavelength conversion sheet of the present embodiment is preferably 10 µm or more because the wavelength conversion sheet can be stably produced. Also, the thickness of the wavelength conversion sheet of the present embodiment is preferably 1 mm or less, more preferably 500 µm or less, and further preferably 200 µm or less, from the viewpoint of enhancing optical characteristics and heat resistance of the wavelength conversion sheet. When the thickness of the wavelength conversion sheet is 1 mm or less, light absorption and light scattering due to the silicone resin can be reduced.

The film thickness of the wavelength conversion sheet of the present embodiment can be obtained, for example, by measuring film thickness at a plurality of positions on the wavelength conversion sheet using a micrometer and calculating the average value thereof. For example, in a case where the shape of the wavelength conversion sheet is a quadrangle, the plurality of positions includes a total of five positions of one central position of the wavelength conversion sheet and four corner positions of the wavelength conversion sheet, and the like.

The wavelength conversion sheet may be formed on a support substrate. As the support substrate, a substrate using known metal, film, glass, ceramic, paper or the like as a forming material can be used.

Specific examples of materials for forming the support substrate include transparent inorganic oxide glass such as quartz glass, borosilicate glass and sapphire; metal plates or foils such as aluminum (including aluminum alloys), zinc, copper and iron; plastic films such as cellulose acetate, polyethylene terephthalate (PET), polyethylene, polyester, polyamide, polyimide, polyphenylene sulfide, polystyrene, polypropylene, polycarbonate, polyvinyl acetal and aramid; papers laminated with the above plastic; papers coated with the above plastic; papers laminated or deposited with the above metal; and plastic films laminated or deposited with the above metal. Among them, an inorganic oxide glass or a metal plate is preferable.

The thickness of the support substrate is preferably 30 µm or more, and more preferably 50 µm or more. When the thickness of the support substrate is 30 µm or more, it has sufficient strength to protect the shape of the wavelength conversion sheet. Also, the thickness of the support substrate is preferably 5000 µm or less, and more preferably 3000 µm or less, from the viewpoint of economy.

### (Method for Producing Wavelength Conversion Sheet)

A method for producing the wavelength conversion sheet according to the present embodiment will be described.

First, a wavelength conversion material-containing silicone resin composition in which a wavelength conversion material is dispersed in the above-described silicone resin composition is prepared.

Additives such as inorganic particles and adhesion aid may be added for diffusing the wavelength conversion material and improving coating properties of the wavelength conversion material-containing silicone resin composition.

These components are blended so as to have a predetermined composition and then homogeneously mixed and dispersed using a known stirring and kneading machine, whereby a wavelength conversion material-containing silicone resin composition can be obtained. Examples of the known stirring and kneading machines include a homogenizer, a rotation/revolution stirrer, a three-roller, a ball mill, a planetary ball mill, and a bead mill. After mixing and dispersing or in a mixing and dispersing process, the wavelength conversion material-containing silicone resin composition may be defoamed as necessary under vacuum or reduced pressure conditions.

Next, the obtained wavelength conversion material-containing silicone resin composition is applied on a support substrate. Application of the wavelength conversion material-containing silicone resin composition can be performed using a known coating apparatus. Examples of the known coating apparatus include a reverse roll coater, a blade coater, a slit die coater, a direct gravure coater, an offset gravure coater, a reverse roll coater, a blade coater, a kiss coater, a natural roll coater, an air knife coater, a roll blade coater, a variable roll blade coater, a two stream coater, a rod coater, a wire bar coater, an applicator, a dip coater, a curtain coater, a spin coater, and a knife coater. Among them, it is preferable to apply the wavelength conversion material-containing silicone resin composition with a slit die coater or an applicator, since the film thickness of the obtained wavelength conversion sheet is likely to be uniform.

Examples of other coating methods include printing methods such as screen printing, gravure printing, and lithographic printing. Among them, it is preferable to apply a wavelength conversion material-containing silicone resin composition by screen printing, from the viewpoint of simplicity.

Next, a coating film formed on the support substrate is heated and cured to obtain a wavelength conversion sheet. Heating of the coating film is performed using an instrument such as a natural convection oven, a blast oven, a vacuum oven, an inert oven, a hot plate, a hot press, or an infrared heater. Among them, a blast oven is preferable from the viewpoint of productivity.

As a heating condition of the coating film, for example, a method of heating at 40°C to 250°C for 5 minutes to 100 hours may be used. The heating time is preferably 1 to 30 hours, more preferably 2 to 10 hours, and further preferably 3 to 8 hours. When the heating time is within this range, it is possible to sufficiently remove the solvent and to prevent coloration upon heating.

After applying the wavelength conversion material-containing silicone resin composition on the support substrate, the coating film may be cured by leaving it in an atmosphere at a temperature of 250°C or less, for example, the coating film may be cured by leaving it in an atmosphere at a temperature of 40°C to 200°C. Also, in curing of the coating film, in order to reduce solvents and water that exist in the wavelength conversion material-containing silicone resin composition and to control the condensation reaction rate of the silicone resin A and the silicone oligomer, for example, the coating film may be cured in a stepwise manner, for example, at 40°C to 60°C for 5 minutes to 30 minutes, subsequently at 60°C to 100°C for 10 minutes to 60 minutes, then at 140°C to 200°C for 30 minutes to 5 hours.

The wavelength conversion sheet thus obtained has excellent resistance. In addition, since the wavelength conversion material-containing silicone resin composition of the present embodiment is excellent in coating properties, the obtained wavelength conversion sheet has less thinning and is excellent in mass productivity.

### (Light-Emitting Device)

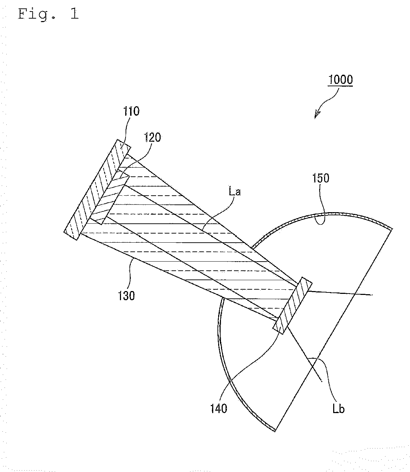

Fig. 1 is a cross-sectional view showing a structure of a light-emitting device including the wavelength conversion sheet of the present embodiment.

The light-emitting device 1000 includes a substrate 110, a laser diode element (light source) 120, a light guide portion 130, a wavelength conversion sheet 140, and a reflecting mirror 150. The wavelength conversion sheet 140 having the above-described configuration can be used.

The laser diode element 120 is arranged on the substrate 110.

In the light guide portion 130, laser light La emitted from the laser diode element 120 is made incident inside, and the laser light La is guided inside. The laser diode element 120 is optically connected to one end of the light guide portion 130, and the wavelength conversion sheet 140 is optically connected to the other end. The light guide portion 130 has a pyramidal shape in which the width gradually decreases from one end side to the other end side, and has a configuration in which the laser light La emitted from the laser diode element 120 is focused on the wavelength conversion sheet 140.

The reflecting mirror 150 is a bowl-shaped member disposed around the wavelength conversion sheet 140, and a curved surface facing the wavelength conversion sheet 140 is a light reflecting surface. The reflecting mirror 150 deflects light emitted from the wavelength conversion sheet 140 in front of the device (irradiation direction of the laser light La).

The laser light La irradiated on the wavelength conversion sheet 140 is converted into white light Lb by the wavelength conversion material contained in the wavelength conversion sheet 140 and output from the light-emitting device 1000.

Although the light-emitting device 1000 has one laser diode element 120, it may have two or more.

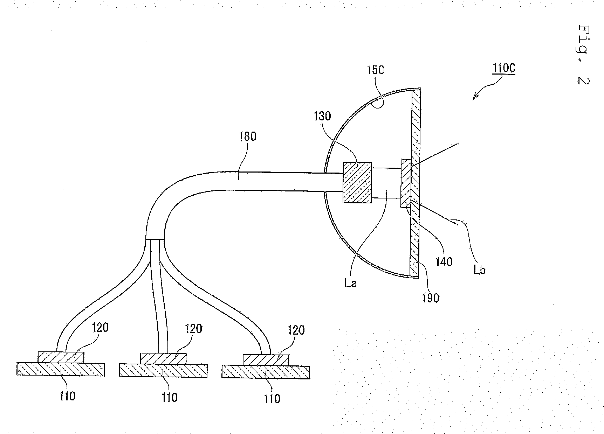

Fig. 2 is a cross-sectional view showing a modified example of the light-emitting device. In Fig. 2 and the following description, the same reference numerals as in Fig. 1 denote the same configurations as those described in Fig. 1.

The light-emitting device 1100 includes a plurality of substrates 110, a plurality of laser diode elements (light sources) 120, a plurality of optical fibers 180, a light guide portion 130, a wavelength conversion sheet 140, a reflecting mirror 150, and a transparent support 190.

In the optical fiber 180, laser light La emitted from the laser diode element 120 is made incident inside, and the laser light La is guided inside. The laser diode element 120 is optically connected to one end of each of the plurality of optical fibers 180. In addition, the plurality of optical fibers 180 are bundled at the other end side, and are optically connected to the light guide portion 130 at the other end in a state of being bundled into one bundle.

In the light guide portion 130, laser light La emitted from the laser diode element 120 is made incident inside, and the laser light La is guided inside and then emitted toward the front of the device. The light guide portion 130 may have a function of converging the laser light La emitted toward the front of the device.

The wavelength conversion sheet 140 is arranged to be opposed to the light guide portion 130 while being separated from the light guide section 130, in a state of being supported by the transparent support 190. The transparent support 190 is provided in front of the device so as to cover an opening portion of the reflecting mirror 150. The transparent support 190 is a member using a transparent material that does not deteriorate due to heat generated during use of the device as a forming material, and for example, a glass plate can be used.

The laser light La irradiated on the wavelength conversion sheet 140 is converted into white light Lb by the wavelength conversion material contained in the wavelength conversion sheet 140 and output from the light-emitting device 1100.

In the light-emitting devices 1000 and 1100, the light source (the laser diode element 120) and the light emitting portion (the wavelength conversion sheet 140) are separated as described above. This facilitates downsizing of the light-emitting device and improvement of designability.

### EXAMPLES

Hereinafter, the present invention will be more specifically described with reference to examples, but the present invention is not limited to the following examples.

### <Evaluation Method>

### [Measurement of Viscosity]

The viscosity of the silicone resin composition was measured using an E type viscometer.

First, a circulating thermostat was connected to a cup of an E type viscometer (model "LVDV-II + pro CP" or "HBDV-II + Pro" or "DV2TLVCJ0" BROOKFIELD), and water temperature was adjusted to 25.0 ± 0.5°C.

Next, about 0.6 mL of the silicone resin composition (sample) was weighed out using a pipette and added to the cup of the E type viscometer. As the cone, "Spindle CPE-40" (shear rate of 7.50 N, cone angle of 0.8°, cone radius of 24 mm) or "Spindle CPE-52" was used (shear rate of 2.00 N, cone angle of 3°, cone radius of 12 mm).

Next, a rotor of the E type viscometer was rotated, the silicone resin composition was held at 1.5 rpm for 5 minutes, then the measured value of the silicone resin composition was read as viscosity.

### [Evaluation of Heat Resistance]

A cured product (disc shape with a diameter of 4 cm and a thickness of 0.5 mm) of the silicone resin composition was heated in an oven at 250°C for 100 hours. To the cured product of the silicone resin composition before and after heating, light transmittance and appearance (presence or absence of wrinkles and cracks) at a wavelength of 400 nm were evaluated.

### [Evaluation of Coating Properties]

A wavelength conversion material-containing silicone resin composition was screen-printed on an aluminum substrate. As a screen printing machine, model "LS-150" (manufactured by NEWLONG SEIMITSU KOGYO Co., Ltd.) was used, and as a screen mask, model "ST250-30-C57" (frame size: 320 mm square, screen type: stainless steel) was used. The screen thickness was 56 µm, the emulsion thickness was 5 µm, and the total film thickness was 61 µm. Also, the squeegee angle (the angle formed by the horizontal surface and the squeegee) was 70 degrees. Subsequently, the appearance of the coating film before curing was evaluated according to the following criteria.

### (Evaluation Criteria)

A...No thinning was observed.
B...Thinning was observed at the corners of the printing area.
C...Thinning was observed at the central part of the printing area.

### [Gel Permeation Chromatography (GPC) Measurement]

A measurement solution was prepared by dissolving the sample (silicone resin) in an eluent and then filtering the solution with a membrane filter with a pore size of 0.45 µm. To the obtained measurement solution, the polystyrene equivalent weight average molecular weight (Mw) was measured under the following conditions.
Device name: HLC-8220 GPC manufactured by Tosoh Corporation
Column: TSKgel SuperHM-H × 2 + SuperH2500 × 1 (inner diameter 6.0 mm × 150 mm × 3)
Eluent: toluene
Flow rate: 0.6 mL/min
Detector: RI detector (polarity:-)
Column temperature: 40°C
Injection volume: 40 µL
Molecular weight standard: standard polystyrene

### [Evaluation of Light Transmittance]

A cured product of a silicone resin composition with a thickness of 500 µm was prepared. To the obtained cured product, the transmittance for light with a wavelength of 400 nm was measured under the following conditions.
Device name: JASCO V-670 Ultraviolet-visible-near-infrared spectrophotometer
Integrating sphere unit (ISN-723/B004861118)
Scanning speed: 1000 nm/min
Measurement wavelength: 200 to 800 nm
Data capture interval: 1.0 nm

### [Solution NMR Measurement]

The abundance ratio of the silicone resin and the structural unit of the oligomer component having the organopolysiloxane used in the following examples as a main chain is a value calculated based on the measurement result of either ¹H-NMR method or ²⁹Si-NMR method measured under the following conditions.

### <¹H-NMR Measurement Conditions>

Device name: ECA-500 manufactured by JEOL RESONANCE Inc.
Observation nucleus: ¹H
Observation frequency: 500.16 MHz
Measurement temperature: room temperature
Measurement solvent: DMSO-d₆
Pulse width: 6.60 µsec (45°)
Pulse repetition time: 7.0 sec
Number of integrations: 16
Sample concentration (sample/measurement solvent): 300 mg/0.6 mL

### <²⁹Si-NMR Measurement Conditions>

Device name: 400-MR manufactured by Agilent Technologies
Observation nucleus: ²⁹Si
Observation frequency: 79.42 MHz
Measurement temperature: room temperature
Measurement solvent: CDCl₃
Pulse width: 8.40 µsec (45°)
Pulse repetition time: 15.0 sec
Number of integrations: 4000
Sample concentration (sample/measurement solvent): 300 mg/0.6 mL

### <Production of Silicone Resin Composition>

### [Example 1]

Resin 1 (polystyrene equivalent weight average molecular weight: 3500) was used as a silicone resin. The structural units contained in Resin 1 are shown in Table 1 below.

**[Table 1]**

| Resin 1 | | | |
|---|---|---|---|
| Structural unit | | | |
| Abundance ratio | 0.03 | 0.23 | 0.74 |

Resin 2 (polystyrene equivalent weight average molecular weight: < 1000) and Resin 3 (polystyrene equivalent weight average molecular weight: 3400) were used as oligomer components.

The structural units contained in Resin 2 are shown in Table 2 below.

**[Table 2]**

| Resin 2 | | | |
|---|---|---|---|
| Structural unit | 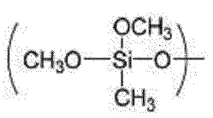 | 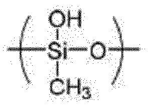 | 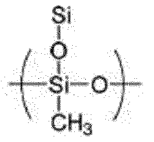 |
| Abundance ratio | 0.39 | 0.49 | 0.12 |

Resin 3 contained 95% by mass or more of a resin composed of structural units shown in Table 3 below. Further, in Resin 3, the sum of areas of peaks present in a region with a polystyrene equivalent weight average molecular weight of 7500 or more is 20% or more to the sum of areas of all peaks, and the sum of areas of peaks present in a region with a polystyrene equivalent weight average molecular weight of 1000 or less was 30% or more to the sum of areas of all peaks.

**[Table 3]**

| Resin 3 | | | | |
|---|---|---|---|---|
| Structural unit | 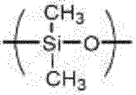 | 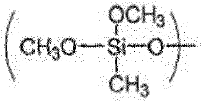 | 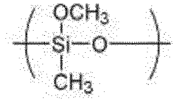 | 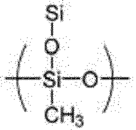 |
| Abundance ratio | 0.20 | 0.10 | 0.45 | 0.25 |

A flask installed in an oil bath was charged with 789.60 g of Resin 1, 96.00 g of propyl acetate and 314.40 g of isopropyl alcohol, and the mixture was stirred at 80°C to dissolve Resin 1 in a solvent.

Then, 8.47 g of Resin 2 and 75.08 g of Resin 3 were added to the obtained solution, and the mixture was stirred for 1 hour to dissolve Resin 2 and Resin 3 in a solvent.

Next, 274.49 g of 2-butoxyethyl acetate and 0.22 g of 3-glycidoxypropyltrimethoxysilane were added to the obtained solution.

The obtained mixture was set in an evaporator, the temperature of the mixture was set at 85°C and the degree of reduced pressure of the evaporator was set at 2.0 kPa. Then, propyl acetate and isopropyl alcohol were distilled off until the total concentration of propyl acetate and isopropyl alcohol in the mixture became 1% by mass or less. Thereafter, 27.76 g of 2-butoxyethyl acetate was added thereto and uniformly stirred to obtain a silicone resin composition of Example 1.

### [Example 2]

A silicone resin composition of Example 2 was obtained in the same manner as in Example 1 except that 32.06 g of dipropylene glycol monomethyl ether was used in place of 27.76 g of 2-butoxyethyl acetate in Example 1.

### [Comparative Example 1]

A liquid A and a liquid B of a transparent sealing resin for a photo device (type "SCR-1016 (A/B)", manufactured by Shin-Etsu Silicone) which was a two-liquid type thermosetting addition reaction type silicone resin were mixed at 50 : 50 (mass ratio) to obtain a silicone resin composition of Comparative Example 1. The silicone resin composition of Comparative Example 1 was a silicone resin composition containing no T unit.

### <Evaluation>

The viscosities of the silicone resin compositions of Example 1, Example 2 and Comparative Example 1 were measured. The results are shown in Table 4.

The viscosity in Table 4 is a value measured using "LVDV-II + Pro" as the E type viscometer and using "Spindle CPE-52" (shear rate of 2.00 N, cone angle of 3°, cone radius of 12 mm) as the cone.

To each of 100 parts by weight of the silicone resin compositions of Example 1 and Example 2 was added 2 parts by weight of a curing accelerator, and then the mixture was stirred. As the curing accelerator, a curing catalyst solution containing 15% by mass of phosphoric acid was used.

Next, the obtained silicone resin composition was cured into a disc shape with a diameter of 4 cm and a thickness of 0.5 mm under heating conditions of 150°C for 5 hours. Heat resistance of the obtained cured product was evaluated by the evaluation method of heat resistance described above. The results are shown in Table 4.

The silicone resin composition of Comparative Example 1 was cured into a disc shape with a diameter of 4 cm and a thickness of 0.5 mm under heating conditions of 150°C for 5 hours. Heat resistance of the obtained cured product was evaluated by the evaluation method of heat resistance described above. The results are shown in Table 4.

In Table 4, the light transmittance shows a ratio (%) of light transmittance of the cured product after heat resistance test to 100% of light transmittance of the cured product before heat resistance test.

The cured products of the silicone resin compositions of Examples 1 and 2 had a light transmittance of 100% even after a heat resistance test at 250°C for 1000 hours, and no occurrence of wrinkles and cracks was observed in appearance.

**[Table 4]**

| Silicone resin composition | Viscosity (mPa·s) | Heat resistance evaluation result | |
|---|---|---|---|
| | | Light transmittance (%) | Appearance |
| Example 1 | 830 | 100 | No occurrence of wrinkles and cracks was observed. |
| Example 2 | 2800 | 100 | No occurrence of wrinkles and cracks was observed. |
| Comparative Example 1 | 270 | 0 | Color turned black and crack was occurred. |

### [Comparative Example 2]

A silicone resin composition of Comparative Example 2 was obtained by further adding 3.7 g of 2-butoxyethyl acetate to 10 g of the silicone resin composition obtained in Example 1. The viscosity of the silicone resin composition of Comparative Example 2 was 32 mPa·s. As for the viscosity, "DV2TLVCJ0" was used as the E type viscometer, and "Spindle CPE-40" (shear rate of 7.50 N, cone angle 0.8°, cone radius 24 mm) was used as the cone.

To 100 parts by weight of the silicone resin composition of Comparative Example 2 was added 2 parts by weight of a curing accelerator, and then the mixture was stirred. As the curing accelerator, a curing catalyst solution containing 15% by mass of phosphoric acid was used.

Next, the obtained silicone resin composition was cured into a disc shape with a diameter of 4 cm and a thickness of 0.5 mm under heating conditions of 150°C for 5 hours. Since wrinkles occurred in the obtained cured product, other evaluations could not be carried out.

### [Comparative Example 3]

A silicone resin composition was obtained in the same manner as in Example 1, except that 97.09 g of 2-butoxyethyl acetate was used in place of 27.76 g of 2-butoxyethyl acetate in Example 1. Then, 30 g of the obtained silicone resin composition was heated at 40°C for 240 hours to obtain a silicone resin composition of Comparative Example 3. The viscosity of the silicone resin composition of Comparative Example 3 was 66000 mPa·s. As for the viscosity, "DV2TLVCJ0" was used as the E type viscometer and "Spindle CPE-52" (shear rate of 2.00 N, cone angle of 3°, cone radius of 12 mm) was used as the cone.

To 100 parts by weight of the silicone resin composition of Comparative Example 3 was added 2 parts by weight of a curing accelerator, and then the mixture was stirred. As the curing accelerator, a curing catalyst solution containing 15% by mass of phosphoric acid was used.

Next, the obtained silicone resin composition was cured into a disc shape with a diameter of 4 cm and a thickness of 0.5 mm under heating conditions of 150°C for 5 hours. Since bubbles were generated in the obtained cured product, other evaluations could not be carried out.

### <Production of Wavelength Conversion Material-Containing Silicone Resin Composition>

### [Examples 3 to 5]

A wavelength conversion material was added to the silicone resin composition of Example 1 in the content each shown in Table 5 below, and then each mixture was sufficiently stirred and mixed to obtain wavelength conversion material-containing silicone resin compositions (ink) of Examples 3 to 5. As the wavelength conversion material, Y₃Al₅O₁₂:Ce (model "C2P", average particle size of 13.6 µm, manufactured by Tokyo Kagaku Kenkyusho Co., Ltd.) was used. The content of the wavelength conversion material in Table 5 is% by mass to the total content of all components contained in the wavelength conversion material-containing silicone resin composition.

**[Table 5]**

| Wavelength conversion material-containing silicone resin composition | Silicone resin composition | Wavelength conversion material content (% by mass) |
|---|---|---|
| Example 3 | Example 1 | 40 |
| Example 4 | Example 1 | 50 |
| Example 5 | Example 1 | 65 |

### (Wavelength Conversion Material-Containing Silicone Resin Composition)

The viscosities of the wavelength conversion material-containing silicone resin compositions of Example 3, Example 4 and Example 5 were measured. The results are shown in Table 6.

The viscosity in Table 6 is a value measured using "HBDV-II + Pro" as the E type viscometer and using "Spindle CPE-40" (shear rate of 7.50 N, cone angle of 0.8°, cone radius of 24 mm) as the cone.

Coating properties of the wavelength conversion material-containing silicone resin compositions of Example 3, Example 4 and Example 5 were evaluated by the evaluation method of coating properties described above. The results are shown in Table 6.

**[Table 6]**

| Wavelength conversion material-containing silicone resin composition | Viscosity (mPa·s) | Coating properties evaluation result |
|---|---|---|
| Example 3 | 5300 | A |
| Example 4 | 12700 | A |
| Example 5 | 69000 | A |

From the above results, it was confirmed that the silicone resin composition and the wavelength conversion material-containing silicone resin composition of the examples had good coating properties, and the cured product after curing had excellent heat resistance.

### INDUSTRIAL APPLICABILITY

According to the present invention, it is possible to provide a silicone resin composition having good coating properties whose cured product after curing has excellent heat resistance.

### DESCRIPTION OF REFERENCE SIGNS

- 110: Substrate
- 120: Laser diode element (light source)
- 130: Light guide portion
- 140: Wavelength conversion sheet
- 150: Reflecting mirror
- La: Laser light
- Lb: White light
- 180: Optical fiber
- 190: Transparent support
- 1000, 1100: Light-emitting device

## Claims

1. A silicone resin composition comprising a silicone resin and a solvent, wherein
the silicone resin composition is a liquid composition having a viscosity of 100 to 50000 mPa·s at 25°C,
the silicone resin comprises a structural unit represented by the following formula (A3), and
the total content of a structural unit represented by the following formula (A1), a structural unit represented by the following formula (A1'), a structural unit represented by the following formula (A2) and the structural unit represented by the following formula (A3) contained in the silicone resin to the total content of all structural units contained in the silicone resin is 80% by mole or more, 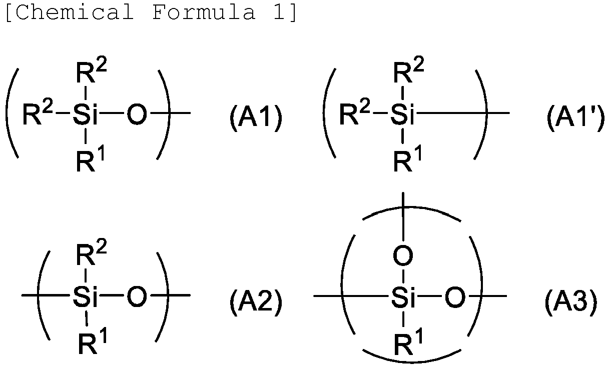 in the formulas (A1), (A1'), (A2) and (A3), R¹ represents an alkyl group having 1 to 10 carbon atoms or an aryl group having 6 to 10 carbon atoms; R² represents an alkoxy group having 1 to 4 carbon atoms or a hydroxyl group; and a plurality of R¹s and R²s each may be the same or different.

2. The silicone resin composition according to claim 1, wherein the content of the structural unit represented by the formula (A3) contained in the silicone resin to the total content of all structural units contained in the silicone resin is 55% by mole or more.

3. The silicone resin composition according to claim 1 or 2, wherein the content of the solvent contained in the silicone resin composition to the total content of all components contained in the silicone resin composition is 10 to 40% by mass.

4. The silicone resin composition according to any one of claims 1 to 3, wherein the silicone resin substantially comprises a condensation type silicone resin.

5. The silicone resin composition according to any one of claims 1 to 4, wherein the R¹ is a methyl group, and the R² is an alkoxy group having 1 to 3 carbon atoms or a hydroxyl group.

6. The silicone resin composition according to any one of claims 1 to 5, wherein the silicone resin has a polystyrene equivalent weight average molecular weight of 1500 to 15000.

7. The silicone resin composition according to any one of claims 1 to 6, wherein
the silicone resin comprises a first oligomer,
the first oligomer comprises a structural unit represented by the following formula (B2), and
the first oligomer has a polystyrene equivalent weight average molecular weight of 1000 to 10000, 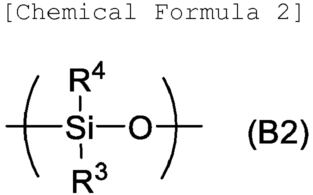 wherein
R³ represents an alkyl group having 1 to 10 carbon atoms or an aryl group having 6 to 10 carbon atoms; and
R⁴ represents an alkyl group having 1 to 10 carbon atoms, an aryl group having 6 to 10 carbon atoms, an alkoxy group having 1 to 4 carbon atoms or a hydroxyl group.

8. The silicone resin composition according to claim 7, wherein the content of the structural unit represented by the formula (B2) contained in the first oligomer in which the R⁴ is an alkoxy group having 1 to 4 carbon atoms or a hydroxyl group to the total content of all structural units contained in the first oligomer is 30 to 60% by mole.

9. The silicone resin composition according to claim 7 or 8, wherein the first oligomer comprises a structural unit represented by the following formula (B1), formula (B1'), formula (B2) or formula (B3), and
the average composition formula of the first oligomer is represented by the following formula (I), 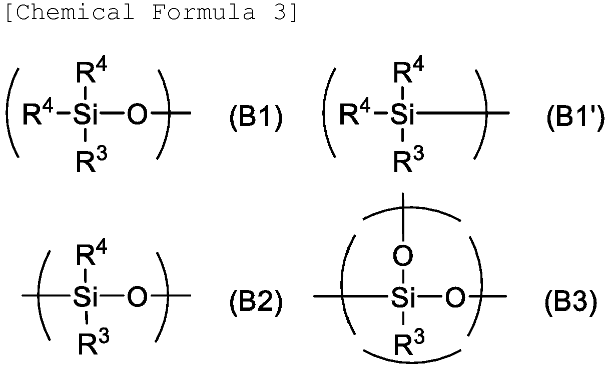 in the formulas (B1), (B1'), (B2) and (B3),
R³ represents an alkyl group having 1 to 10 carbon atoms or an aryl group having 6 to 10 carbon atoms;
R⁴ represents an alkyl group having 1 to 10 carbon atoms, an aryl group having 6 to 10 carbon atoms, an alkoxy group having 1 to 4 carbon atoms or a hydroxyl group; and
a plurality of R³s and R⁴s each may be the same or different,
(R⁵)ₙSi(OR⁶)ₘO_{(4-n-m)/2} ... (I)
wherein
R⁵ represents an alkyl group having 1 to 10 carbon atoms or an aryl group having 6 to 10 carbon atoms;
R⁶ represents an alkyl group having 1 to 10 carbon atoms, an aryl group having 6 to 10 carbon atoms or a hydrogen atom;
n represents a real number satisfying 1 < n < 2; and m represents a real number satisfying 0 < m < 1.

10. The silicone resin composition according to any one of claims 7 to 9, wherein the molar ratio of the following T unit and D unit contained in the first oligomer is from 60 : 40 to 90 : 10,
wherein,
T unit means a structural unit containing a silicon atom bonded to three oxygen atoms, and
D unit means a structural unit containing a silicon atom bonded to two oxygen atoms.

11. The silicone resin composition according to any one of claims 1 to 10, wherein
the silicone resin comprises a second oligomer,
the second oligomer contains a structural unit represented by the formula (A1), the formula (A1'), the formula (A2) or the formula (A3),
the content of the structural unit represented by the formula (A3) contained in the second oligomer, to the total content of the structural unit represented by the formula (A1), the structural unit represented by the formula (A1'), the structural unit represented by the formula (A2) and the structural unit represented by the formula (A3), is 0 to 30% by mole, and
the second oligomer has a polystyrene equivalent weight average molecular weight of less than 1500.

12. A wavelength conversion material-containing silicone resin composition comprising the silicone resin composition as defined in any one of claims 1 to 11 and a wavelength conversion material.

13. The wavelength conversion material-containing silicone resin composition according to claim 12, which is a liquid composition having a viscosity of 1000 to 500000 mPa·s at 25°C.

14. The wavelength conversion material-containing silicone resin composition according to claim 12 or 13, wherein the content of the wavelength conversion material to the total content of all components contained in the wavelength conversion material-containing silicone resin composition is 40% by mass or more.

15. A wavelength conversion material-containing sheet comprising a cured product of the wavelength conversion material-containing silicone resin composition as defined in any one of claims 12 to 14 as a forming material.
